(19) Europäisches Patentamt
European Patent Office
Office européen des brevets

(11) **EP 2 645 443 A1**

(12) **EUROPEAN PATENT APPLICATION**
published in accordance with Art. 153(4) EPC

(43) Date of publication:
**02.10.2013 Bulletin 2013/40**

(21) Application number: **11843161.8**

(22) Date of filing: **22.11.2011**

(51) Int Cl.:
***H01L 51/50*** (2006.01) ***C07C 211/57*** (2006.01)
***C07C 211/58*** (2006.01) ***C07F 7/10*** (2006.01)
***C09K 11/06*** (2006.01)

(86) International application number:
**PCT/JP2011/006489**

(87) International publication number:
**WO 2012/070227 (31.05.2012 Gazette 2012/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.11.2010 JP 2010260607**

(71) Applicant: **Idemitsu Kosan Co., Ltd.**
**Chiyoda-ku**
**Tokyo 100-8321 (JP)**

(72) Inventors:
- **MIZUKI, Yumiko**
  **Sodegaura-shi**
  **Chiba 299-0293 (JP)**
- **SAITO, Hiroyuki**
  **Sodegaura-shi**
  **Chiba 299-0293 (JP)**
- **KUMA, Hitoshi**
  **Sodegaura-shi**
  **Chiba 299-0293 (JP)**
- **KAWAMURA, Yuichiro**
  **Sodegaura-shi**
  **Chiba 299-0293 (JP)**

(74) Representative: **Gille Hrabal**
**Patentanwälte**
**Brucknerstrasse 20**
**40593 Düsseldorf (DE)**

(54) **ORGANIC ELECTROLUMINESCENT ELEMENT**

(57) An organic electroluminescence device including an anode, an emitting layer, a blocking layer, an electron-injecting layer and a cathode in this sequence, the emitting layer including a host and a styrylamine derivative having a specific structure; and the triplet energy $E^Tb$ of the blocking layer being larger than the triplet energy $E^Th$ of the host

FIG.2B

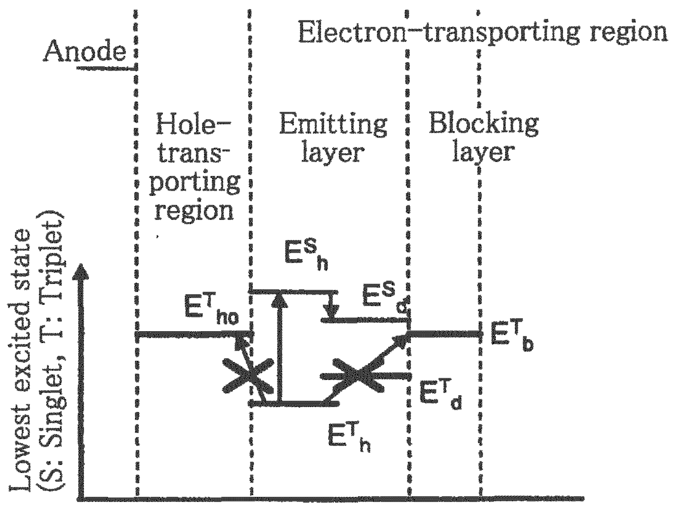


EP 2 645 443 A1

**Description**

Technical Field

The invention relates to an organic electroluminescence (EL) device, in particular, to a highly efficient organic EL device.

Background Art

An organic EL device can be classified into two types, i.e. a fluorescent EL device and a phosphorescent EL device according to its emission principle. When a voltage is applied to an organic EL device, holes are injected from an anode, and electrons are injected from a cathode, and holes and electrons are recombined in an emitting layer to form an exciton. According to the repository of electron spins, singlet excitons and triplet excitons are formed at an amount ratio of 25%:75%. In a fluorescent EL device which uses emission by singlet excitons, the limited value of the internal quantum efficiency is believed to be 25%. Technology for prolonging the lifetime of a fluorescent EL device utilizing a fluorescent material has been recently improved. This technology is being applied to a full-color display of portable phones, TVs, or the like. However, a fluorescent EL device is required to be improved in efficiency is used.

In association with the technology of improving the efficiency of a fluorescent EL device, several technologies are disclosed in which emission is obtained from triplet excitons, which have heretofore been not utilized effectively. For example, in Non-Patent Document 1, a non-doped device in which an anthracene-based compound is used as a host material is analyzed. As a result of the analysis, a mechanism is found that singlet excitons are formed by fusion by collision of two triplet excitons, whereby fluorescent emission is increased. However, Non-Patent Document 1 only discloses that fluorescent emission is increased only by fusion by collision of triplet excitons in a non-doped device in which only a host material is used. In this technology, an increase in efficiency by triplet excitons is as low as 3 to 6%.

Non- Patent Document 2 reports that a blue fluorescent device exhibits an internal quantum efficiency of 28.5%, which exceeds 25%, which is the conventional theoretical limit value. However, no technical means for attaining an efficiency exceeding 25% is disclosed. In respect of putting a full- color organic EL TV into practical use, a further increase in efficiency has been required.

In Patent Document 1, another example is disclosed in which triplet excitons are used in a fluorescent device. In normal organic molecules, although the lowest excited triplet state (T1) is lower than the lowest excited singlet state (S1), the higher triplet excited state (T2) may be higher than S1. Due to the occurrence of transition from T2 to S1 in such a case, it is believed that emission from the singlet excited state can be obtained. However, actually, the external quantum efficiency is about 6% (the internal quantum efficiency is 24% when the outcoupling efficiency is taken as 25%), which does not exceed the value of 25% which has conventionally been believed to be the limit value. The mechanism disclosed in this document is that emission is obtained due to the intersystem crossing from the triplet excited state to the singlet excited state in a single molecule. Generation of single triplets by collision of two triplet excitons as disclosed in Non-Patent Document 1 is not occurred in this mechanism.

Patent Documents 2 and 3 each disclose a technology in which a phenanthroline derivative such as BCP (bathocuproin) and BPhen is used in a hole-blocking layer in a fluorescent device to increase the density of holes in the interface between a hole-blocking layer and an emitting layer, enabling recombination to occur efficiently. However, a phenanthroline derivative such as BCP (bathocuproin) and BPhen is vulnerable to holes and poor in resistance to oxidation, and the performance thereof is insufficient in respect of prolonging the lifetime of a device.

In Patent Documents 4 and 5, a fluorescent device is disclosed in which an aromatic compound such as an anthracene derivative is used as a material for an electron-transporting layer which is in contact with an emitting layer. However, this is a device which is designed on the assumption that generated single triplets emit fluorescence within a short period of time. Therefore, no consideration is made on the relationship with the triplet energy of an electron-transporting layer which is normally designed in a phosphorescent device. Actually, since the triplet energy of an electron-transporting layer is smaller than the triplet energy of an emitting layer, triplet excitons generated in an emitting layer are diffused to an electron-transporting layer, and then, subjected to thermal deactivation. Therefore, it is difficult to exceed the theoretical limit value of 25% of the conventional fluorescent device. Furthermore, since the affinity of an electron-transporting layer is too large, electrons are not injected satisfactorily to an emitting layer of which the affinity is small, and hence, improvement in efficiency cannot necessarily be attained. In addition, Patent Document 6 discloses a blue emitting device in which a fluoranthene-based dopant which has a long life and a high efficiency. This device is not always highly efficient

On the other hand, a phosphorescent device directly utilizes emission from triplet excitons. Since the singlet exciton energy is also converted to triplet excitons by the spin conversion within an emitting molecule, it is expected that an internal quantum efficiency of nearly 100% can be attained, in principle. For the above-mentioned reason, since a phosphorescent device using an Ir complex was reported by Forrest et at in 2000, a phosphorescent device has attracted

attention as a technology of improving efficiency of an organic EL device. Although a red phosphorescent device has reached the level of practical use, green and blue phosphorescent devices have a lifetime shorter than that of a fluorescent device. In particular, as for a blue phosphorescent device, there still remains a problem that not only lifetime is short but also color purity or luminous efficiency is insufficient. For these reasons, phosphorescent devices have not yet been put into practical use.

Related Art Documents

Patent Documents

Patent Document 1: JP- A- 2004- 214180
Patent Document 2: JP- A- H10- 79297
Patent Document 3: JP- A- 2002- 100478
Patent Document 4: JP- A- 2003- 338377
Patent Document 5: WO2008/062773
Patent Document 6: WO2007/100010
Patent Document 7: JP- T- 2002- 525808
Patent Document 8: USP 7,018,723

Non-Patent Documents

Non-Patent Document 1: Journal of Applied Physics, 102, 114504 (2007)
Non-Patent Document 2: SID 2008 DIGEST, 709 (2008)

Summary of the invention

The inventors noticed a phenomenon stated in the Non-Patent Document 1, i.e. a phenomenon in which singlet excitons are generated by collision and fusion of two triplet excitons (hereinafter referred to as Triplet-Triplet Fusion = TTF phenomenon), and made studies in an attempt to improve efficiency of a fluorescent device by allowing a TFT phenomenon to occur efficiently. Specfically, the inventors have found that when a material of which the triplet energy is larger than that of a host in a layer of an emitting layer which is adjacent to an interface on the cathode side (referred to as a "blocking layer" in the invention), triplet excitons are confined within an emitting layer to allow a TTF phenomenon to occur efficiently, whereby improvement in efficiency and prolongation of lifetime of a fluorescent device can be realized.
It is known that, in a phosphorescent device, a high efficiency can be attained by using a material having large triplet energy in a layer of an emitting layer which is adjacent to an interface on the cathode side in order to prevent diffusion of triplet excitons to the emitting layer, of which the exciton life is longer than that of singlet excitons. JP- T- 2002- 525808 discloses a technology in which a blocking layer comprising BCP (bathocuproin), which is a phenanthroline derivative, is provided in such a manner that it is adjacent to an emitting layer, whereby holes or excitons are confined to achieve a high efficiency. USP 7, 018, 723 discloses use of a specific aromatic ring compound in a hole- blocking layer in an attempt to improve efficiency and prolonging lifetime. In these documents, for a phosphorescent device, the above- mentioned TTF phenomenon is called TTA (Triplet- TripletAnnihilation: triplet pair annihilation) . That is, the TTF phenomenon is known as a phenomenon which deteriorates emission from triplet excitons which is the characteristics of phosphorescence. In a phosphorescent device, efficient confinement of triplet excitons within an emitting layer does not necessarily result in improvement in efficiency.
According to the invention, the following organic EL device or the like are provided.

1. An organic electroluminecence device comprising an anode, an emitting layer, a blocking layer, an electron-injecting layer and a cathode in this sequence,
the emitting layer comprises a host and a styrylamine derivative represented by the following formula (1) or (2); and the triplet energy of the blocking layer is larger than the triplet energy of the host

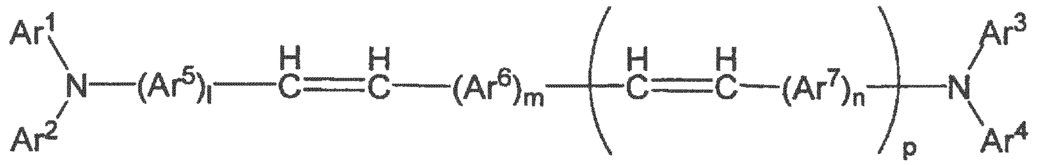

(1)

in the formula (1), $Ar^1$ to $Ar^4$ are independently a substituted or unsubstituted aryl group or a substituted or unsubstituted heteroaryl group;
$Ar^5$ to $Ar^7$ are independently a substituted or unsubstituted arylene group or a substituted or unsubstituted heteroarylene group;
l, m and n are independently an integer of 1 to 3 and p is an integer of 0 to 2;
when l is 2 or more, $Ar^5$s may be the same or different;
when m is 2 or more, $Ar^6$s may be the same or different;
when p is 1 or more and n is 2 or more, $Ar^7$s may be the same or different;
when p is 2 or more and n is 1, $Ar^7$s may be the same or different;
the substituents of $Ar^1$ to $Ar^7$ are a halogen atom, an alkyl group, an aryl group, a heteroaryl group, an alkoxy group, a substituted or unsubstituted silyl group or a cyano group;
provided that when p is 0 and $(Ar^5)_l$ is a biphenylene group, $(Ar^6)_m$ is an arylene group having 7 or more carbon atoms, and when p is 0 and $(Ar^6)_m$ is a biphenylene group, $(Ar^5)_l$ is an arylene group having 7 or more carbon atoms;

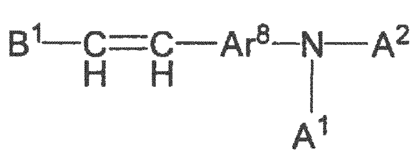

(2)

in the formula (2), $Ar^8$ is a substituted or unsubstituted arylene group or a substituted or unsubstituted heteroarylene group;
$A^1$ and $A^2$ are independently an alkyl group, a substituted or unsubstituted aryl group, a substituted or unsubstituted heteroaryl group or a group represented by the following formula (3):

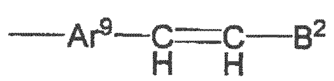

(3)

in the formula (3), $Ar^9$ is a substituted or unsubstituted arylene group or a substituted or unsubstituted heteroarylene group, $B^2$ is a substituted or unsubstituted aryl group or a substituted or unsubstituted heteroaryl group; when $A^1$ and $A^2$ are both groups represented by the formula (3), $Ar^9$ and $B^2$ may be the same or different;
$B^1$ is a substituted or unsubstituted aryl group or a substituted or unsubstituted heteroaryl group;
the substituents of $Ar^8$ to $Ar^9$, $A^1$, $A^2$, $B^1$ and $B^2$ are a halogen atom, an alkyl group, an aryl group, a heteroaryl group, an alkoxy group or a substituted or unsubstituted silyl group or a cyano group.

2. The organic electroluminescence device according to 1, wherein $Ar^1$ to $Ar^4$, $A^1$, $A^2$, $B^1$ and $B^2$ each have at least one or more substituents selected from a cyano group, a fluorine atom and a substituted or unsubstituted silyl group.

3. The organic electroluminescence device according to 1 or 2, wherein, in the formula (1), p is 0, l is 1 and m is 1.

4. The organic electroluminescence device according to 1 or 2, wherein, in the formula (1), p is 1, l is 1, m is 1 and n is 1.

5. The organic electroluminescence device according to 1 or 2, wherein, in the formula (1), p is 0, l is 1 and m is 2.

6. The organic electroluminescence device according to 1 or 2, wherein, in the formula (1), p is 0, l is 2 and m is 2.

7. The organic electroluminescence device according to 1 or 2, wherein, in the formula (1), p is 1, l is 2, m is 2 and n is 2.

8. The organic electroluminescence device according to 1, wherein, in the formula (1), at least one of $Ar^5$ to $Ar^7$ is a substituted or unsubstituted fluorenyl group, a substituted or unsubstituted naphthyl group or a substituted or unsubstituted phenyl group.

9. The organic electroluminescence device according to 1, wherein, in the formula (2), at least one of $A^8$ and $Ar^9$ is a substituted or unsubstituted fluorenyl group, a substituted or unsubstituted naphthyl group or a substituted or unsubstituted phenyl group.

10. The organic electroluminescence device according to any of 1 to 8, wherein, in the formula (1), a structure between two nitrogens is represented by any of the following formulas:

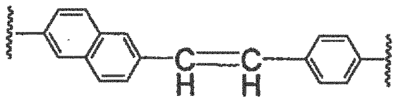

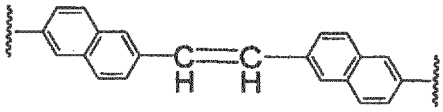

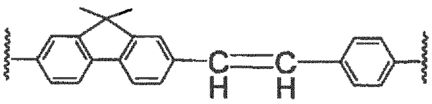

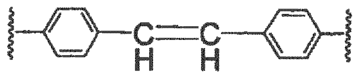

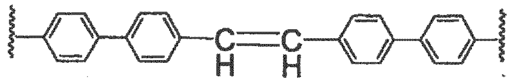

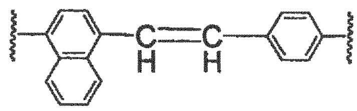

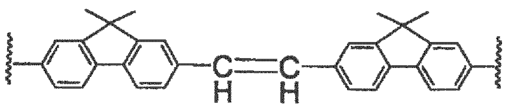

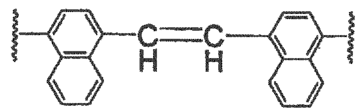

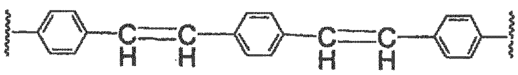

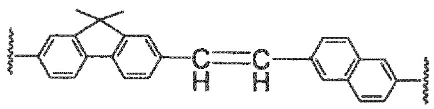

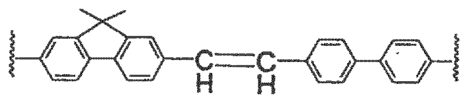

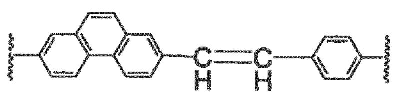

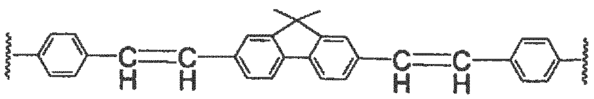

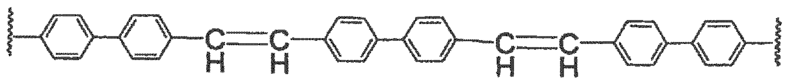

wherein in the formulas, the wavy line at the both ends continue to a nitrogen atom.

The invention can provide a highly efficient organic EL device which can, efficiency induce a TTF phenomenon within an emitting layer.

BRIEF DESCRIPTION OF THE DRAWINGS

FIG. 1 is a view showing one example of the organic EL device according to the first embodiment of the invention;
FIG 2A is a view showing the relationship between the energy gap of each layer of the invention;
FIG 2B is a view showing the action based on the relationship of the energy gap of each layer of the invention;
FIG 3 is a view showing the method for measuring the transitional EL waveform;
FIG. 4 is a view showing the method for measuring the ratio of emission intensity derived from TTF;
FIG. 5 is a view showing one example of the organic EL device according to the second embodiment of the invention;
FIG. 6 is a view showing one example of the organic EL device according to the third embodiment of the invention; and
FIG. 7 is a view showing one example of the organic EL device according to the fourth embodiment of the invention.

MODE FOR CARRYING OUT THE INVENTION

<First embodiment>

The invention utilizes a TTF phenomenon. First, an explanation is made on a TTF phenomenon.
Holes and electrons injected from an anode and a cathode are recombined with in an emitting layer to generate excitons. As for the spin state, as is conventionally known, singlet excitons account for 25% and triplet excitons account for 75%. In a conventionally known fluorescent device, light is emitted when singlet excitons which account for 25% are relaxed to the ground state. The remaining triplet excitons which account for 75% are returned to the ground state without emitting light after passing through a thermal deactivation process. Accordingly, the theoretical limit value of the internal quantum efficiency of a conventional fluorescent device is believed to be 25%.

The behavior of triplet excitons generated within an organic substance has been theoretically examined. According to S.M. Bachilo et al. (J. Phys. Cem. A, 104, 7711 (2000) ), assuming that high- order excitons such as quintet excitons are quickly returned to the triplet excitons, triplet excitons (hereinafter abbreviated as $^3A^*$) collide with each other with an increase in the density thereof, whereby a reaction shown by the following formula occurs. In the formula, $^1A$ represents the ground state and $^1A^*$ represents the lowest excited singlet excitons.

$$^3A^* + {}^3A^* \rightarrow (4/9)\,{}^1A + (1/9)\,{}^1A^* + (13/9)\,{}^3A^*$$

That is, a reaction shown by $5\,{}^3A^* \rightarrow 4\,{}^1A + {}^1A^*$ occurs, and it is expected that, among 75% of triplet excitons initially generated, one fifth thereof, that is 20%, is changed to singlet excitons. Therefore, the amount of singlet excitons which contribute to emission is 40%, which is a value obtained by adding 15% ((75% $\times$ (1/5) = 15%) to 25%, which is the amount ratio of initially generated singlet excitons. At this time, the ratio of luminous intensity derived from TTF (TTF ratio) relative to the total luminous intensity is 15/40, that is 37.5%. In addition, assuming that singlet excitons are generated by collision of 75% of initially- generated triplet excitons (that is, one singlet exciton is generated from two triplet excitons), a significantly high internal quantum efficiency of 62.5% is obtained which is a value obtained by adding 37.5% ((75% $\times$ (1/2) = 37.5%) to 25%, which is the amount ratio of initially generated singlet excitons. At this time, the TTF ratio is 60% (37.5/62.5) .

FIG. 1 is a diagrammatical view of an organic EL device showing one example of the first embodiment of the invention. FIG. 2A is a view diagrammatically showing the lowest excited singlet energy level and the lowest excited triplet energy level of each layer. In the invention, the.triplet energy is referred to as a difference between energy in the lowest excited triplet state and energy in the ground state. The singlet energy (often referred to as an energy gap) is referred to as a difference between energy in the lowest excited singlet state and energy in the ground state. In the organic EL device shown in FIG. 1, a hole-transporting region 50, an emitting layer 20, an electron-transporting region 30 and a cathode 40 are stacked in a sequential order from an anode 10. It is preferred that a hole-transporting region 50 be provided between an anode 10 and an emitting layer 20. In the invention, if reference is made simply to the blocking layer, it means a layer having a function of blocking triplet energy. Therefore, the blocking layer in the invention has a function different from that of the hole-blocking layer or the charge-blocking layer.

In FIG 2A, holes injected from an anode are then injected to an emitting layer through a hole-transporting region. Electrons injected from a cathode are then injected to an emitting layer through an electron-transporting region. Thereafter, holes and electrons are recombined in an emitting layer, whereby singlet excitons and triplet excitons are generated. There are two manners as for the occurrence of recombination. Specifically, recombination may occur either on host molecules or on dopant molecules. As shown in FIG 2A, the triplet energy of a hole-transporting region, that of a host and that of a dopant are taken as $E^T_{h0}$, $E^T_h$ and $E^T_d$, respectively. The singlet triplet energy of the host and the dopant are taken as $E^S_h$ and $E^S_d$, respectively.

In the invention, the electron-transporting region has a blocking layer in a part which is adjacent to the emitting layer. The blocking layer has a function of preventing diffusion of triplet excitons generated in the emitting layer to the electron-transporting region, and confining the triplet excitons in the emitting layer to increase the density of the triplet excitons, thereby allowing a TTF phenomenon to occur efficiently. In order to prevent diffusion of triplet excitons, it is preferred that the triplet energy $E^T_b$ of the blocking layer be larger than $E^T_h$, further, than $E^T_d$. Since the blocking layer prevents triplet excitons from being diffused to the electron-transporting region, in the emitting layer, triplet excitons of a host become singlet excitons efficiently, and the singlet excitons transfer to a dopant, and undergo optical energy deactivation.
As for materials for forming the blocking layer, aromatic hydrocarbon ring compounds are preferably selected. More preferably, polycyclic aromatic compounds are selected. Due to the resistance to holes of these materials, the blocking layer is hard to be degraded, whereby the lifetime of a device is prolonged.

FIG 2B shows a particularly preferable embodiment. It is preferred that the host and the dopant satisfy the relationship $E^T_h < E^T_d$. By satisfying this relationship, as shown in FIG 2B, the triplet excitons recombined and generated on the host do not transfer to the dopant having a higher triplet energy. Further, the triplet excitons recombined and generated on dopant molecules transfer energy to the host molecules rapidly. That is, singlet excitons are generated by a mechanism in which triplet excitons collide on the host efficiently by a TTF phenomenon without the transfer of the triplet excitons of the host to the dopant. Further, since the singlet energy of the dopant $E^S_d$ of the dopant is smaller than the singlet energy $E^S_h$ of the host, singlet excitons generated by a TTF phenomenon transfer energy from the host to the dopant, thereby contributing to the fluorescence emission of the dopant In principal, in the dopant used in a fluorescent device, transfer from the excited triplet state to the ground state is prohibited. In such transition, the triplet excitons do not undergo optical deactivation, and undergo thermal deactivation. However, by allowing the relationship of the triplet energy of the host and the triplet energy of the dopant to be as mentioned above, singlet excitons are generated more efficiently by the collision of the triplet excitons before the triplet excitons undergo thermal deactivation, thereby leading to improvement in luminous efficiency.

In the electron-transporting region, between the blocking layer and the cathode, an electron-injecting layer which facilitates injection of electrons from the cathode is provided. Specific examples include a stacked body of a normal electron transporting material and an alkaline metal compound, an alkaline metal or an alkaline metal complex, or one obtained by adding a donor represented by an alkaline metal compound, an alkali metal or an alkaline metal complex to a material forming a blocking layer.

The emitting layer of the invention comprises a host and a specific styrylamine derivative. The styrylamine derivative used in the invention is represented by the following formula (1):

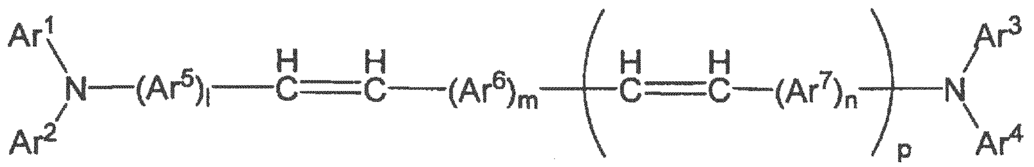

(1)

In the formula (1), $Ar^1$ to $Ar^4$ are independently a substituted or unsubstituted aryl group (preferably one having 6 to 20 carbon atoms that form a ring (hereinafter referred to as "ring carbon atoms")) or a substituted or unsubstituted heteroaryl group (preferably one having 5 to 20 atoms that form a ring (hereinafter referred to as "ring atoms")). It is preferred that $Ar^1$ to $Ar^4$ be independently a substituted or unsubstituted aryl group having 6 to 20 ring carbon atoms. It is more preferred that $Ar^1$ to $Ar^4$ be be a substituted or unsubstituted phenyl group or naphthyl group.

$Ar^5$ to $Ar^7$ are independently a substituted or unsubstituted arylene group (preferably one having 6 to 20 ring carbon atoms or a substituted or unsubstituted heteroarylene group (preferably one having 5 to 20 ring atoms) . It is preferred that $Ar^5$ to $Ar^7$ be independently a substituted or unsubstituted arylene group having 6 to 20 ring carbon atoms. A substituted or unsubstituted phenylene group, a substituted or unsubstituted naphthylene group, a substituted or unsubstituted fluorenylene group or a substituted or unsubstituted phenanthrene group is more preferable. At least one of $Ar^5$ to $Ar^7$ is a substituted or unsubstituted phenylene group, a substituted or unsubstituted naphthylene group, a substituted or unsubstituted fluorenylene group or a substituted or unsubstituted phenanthrene group. The substituent is preferably an alkyl group (an alkyl group having 1 to 6, more preferably 1 to 4 carbon atoms) .

l, m and n are independently an integer of 1 to 3, preferably 1. When l is 2 or more, $Ar^5$s may be the same or different, and when m is 2 or more, $Ar^6$s may be the same or different When p is 1 or more and n is 2 or more, $Ar^7$s may be the same or different. When p is 2 or more and n is 1, $Ar^7$s may be the same or different.

p is 0 to 2, preferably 0 to 1, with an integer of 0 being more preferable. If p is 0, it becomes a single bond.

The aryl group, the arylene group, the heteroaryl group and the heteroarylene group are independently a group formed of one or more rings. A plurality of rings may be fused or not fused.

The "ring carbon atom" is carbon atoms that constitute a saturated ring, an unsaturated ring or an aromatic ring. The "ring atom" means carbon atoms or hetero atoms that constitute a hetero ring (a saturated ring, an unsaturated ring and an aromatic ring).

The aryl group having 6 to 20 ring carbon atoms represented by $Ar^1$ to $Ar^4$ is an aryl group having 6 to 12 ring carbon atoms.

Specific examples of the aryl group include a phenyl group, a 1-naphthyl group, a 2-naphthyl group, a 1-anthrhyl group, a 2-anthryl group, a 9-anthryl group, a 1-phenanthryl group, a 2-phenanthryl group, a 3-phenanthryl group, a 4-phenanthryl group, a 9-phenanthryl group, a naphthacenyl group, a pyrenyl group, a chrysenyl group, a benzo[c]phenanthryl group, a benzo[g]chrysenyl group, a triphenylenyl group, a 1-fluorenyl group, a 2-fluorenyl group, a 3-fluorenyl group, a 4-fluorenyl group, a 9-fluorenyl group, a benzofluorenyl group, a dibenzofluorenyl group, a 2-biphenylyl group, a 3-biphenylyl group, a 4-biphenylyl group, a terphenyl group, a fluoranthenyl group or the like can be given. Of these, a phenyl group,

a biphenyl group, a tolyl group, a xylyl group and a 1-naphthyl group are preferable.

The heteroaryl group having 5 to 20 ring atoms represented by $Ar^1$ to $Ar^4$ is preferably a heteroaryl group having 5 to 14 ring atoms.

Specific examples of the heteroaryl group include a pyrroloyl group, a pyrazinyl group, a pyridinyl group, an indolyl group, an isoindolyl group, an imidazolyl group, a furyl group, a benzofuranyl group, an isobenzofuranyl group, a 1-dibenzofuranyl group, a 2-dibenzofuranyl group, a 3-dibenzofuranyl group, a 4-dibenzofuranyl group, a 1-dibenzothiophenyl group, a 2-dibenzothiophenyl group, a 3-dibenzothiophenyl group, a 4-dibenzothiophenyl group, a quinolyl group, an isoquinolyl group, a quinoxalinyl group, a 1-carbazolyl group, a 2-carbazolyl group, a 3-carbazolyl group, a 4-carbazolyl group, a 9-carbazolyl group, a phenanthridinyl group, an acryzinyl group, a phenanthrolinyl group, a phenazinyl group, a phenothiazinyl group, a phenoxazinyl group, an oxazolyl group, an oxadiazolyl group, a furazanyl group, a thienyl group and a benzothiophenyl group. Of these, a 1-dibenzofuranyl group, a 2-dibenzofuranyl group, a 3-dibenzofuranyl group, a 4-dibenzofuranyl group, 1-dibenzothiophenyl group, a 2-dibenzothiophenyl group, a 3-dibenzothiophenyl group, a 4-dibenzothiophenyl group, a 1-carbazolyl group, a 2-carbazolyl group, a 3-carbazolyl group, a 4-carbazolyl group and a 9-carbazolyl group are preferable.

Specific examples of the arylene group having 6 to 20 (preferably 6 to 12) ring carbon atoms or the heteroarylene group having 5 to 20 (preferably 5 to 14) ring atoms represented by $Ar^5$, $Ar^6$ and $Ar^7$ include divalent groups corresponding to the aryl group having 6 to 20 ring carbon atoms or the heteroaryl group having 5 to 20 ring atoms represented by $Ar^1$ to $Ar^4$. A divalent group such as a phenyl group, a fluorenyl group, a naphthyl group, a phenanthryl group, a biphenylyl group, a dibenzofluorenyl group, a pyridinyl group, an isoquinolyl group or the like can be given.

As the substituted or unsubstituted arylene group represented by $Ar^5$, $Ar^6$ and $Ar^7$, the following groups can be exemplified.

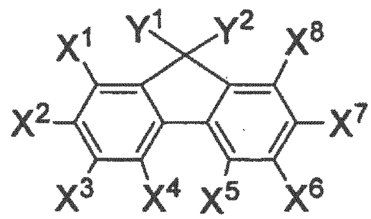

In the formula, $Y^1$, $Y^2$, $X^1$ to $X^8$ are independently a hydrogen atom, an alkyl group, a cycloalkyl group, a substituted or unsubstituted aryl group or a substituted silyl group. $X^1$ and $X^2$, $X^2$ and $X^3$, $X^3$ and $X^4$, $X^5$ and $X^6$, $X^6$ and $X^7$, and $X^7$ and $X^8$ may be bonded with each other to form a saturated or unsaturated ring structure as shown below. The ring structure may further have a substituent However, if a ring structure is formed, any two selected from $X^1$ to $X^8$ and the bonding parts of the ring structure are bonded as a single bond.

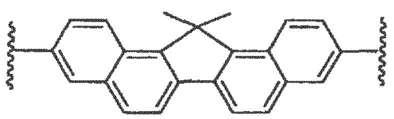
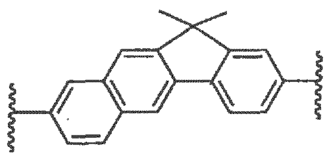
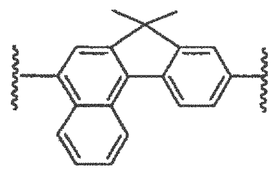

wherein in the formulas, the wavy line at the both ends continue to a bonding part as a single bond.

The substituents of $Ar^1$ to $Ar^7$ mentioned above are a halogen atom, an alkyl group, an aryl group, a heteroaryl group, an alkoxy group, a substituted or unsubstituted silyl group or a cyano group. Of these, a substituted or unsubstituted silyl group, a cyano group and a fluorine atom are preferable.

As the alkyl group, a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group or the like can be given.

The alkyl group as mentioned above preferably has 1 to 10 carbon atoms, with 1 to 6 being further preferable. Of these, a methyl group, an ethyl group, a propyl group, an isopropyl group, an n-butyl group, an s-butyl group, an isobutyl group, a t-butyl group, an n-pentyl group and an n-hexyl group are preferable.

The alkoxy group is represented by -OY Examples ofY include the above-mentioned alkyl group. As the alkoxy group, a methoxy group, an ethoxy group or the like can be given, for example.

The substituted silyl group includes a substituted or unsubstituted alkylsilyl group (including a mono-, di- and trialkylsilyl group) having 1 to 20 carbon atoms and a substituted or unsubstituted arylsilyl group having 6 to 30 carbon atoms (including an aryldialkylsilyl group, a diarylalkylsilyl group and a triarylsilyl group).

The above-mentioned alkylsilyl group having 1 to 20 carbon atoms is preferably an alkylsilyl group having 1 to 10 carbon atoms, and more preferably an alkylsilyl group having 1 to 6 carbon atoms. Specific examples of the alkylsilyl group include a trimethylsilyl group, a triethylsilyl group, a t-butyldimethylsilyl group, a vinyldimethylsilyl group and a propyldimethylsilyl group. The above-mentioned arylsilyl group having 6 to 30 carbon atoms is preferably an arylsilyl group having 6 to 20 carbon atoms, more preferably an arylsilyl group having 6 to 10 carbon atoms. Specific examples of the arylsilyl group include a triphenylsilyl group, a phenylsimethylsilyl group, a t-butyldiphenylsilyl group, a tritolylsilyl group, a trixylylsilyl group and a trinaphthylsilyl group.

As the halogen atom, fluorine, chlorine, bromine, iodine or the like can be given, with fluorine being preferable.

The structure between two nitrogen atoms in the above formula (1) is exemplified below.

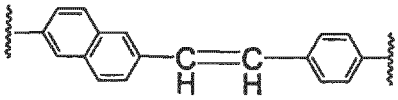

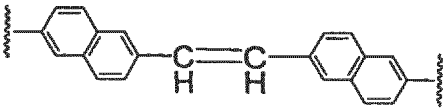

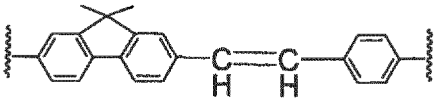

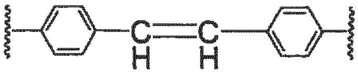

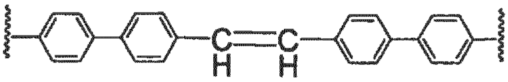

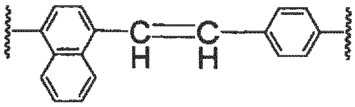

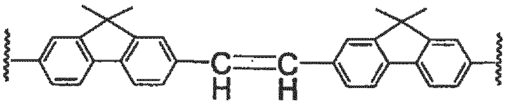

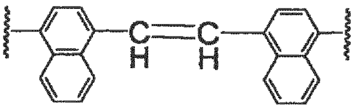

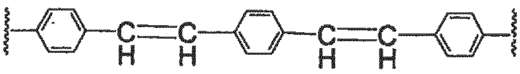

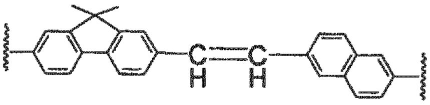

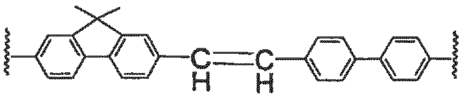

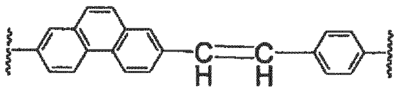

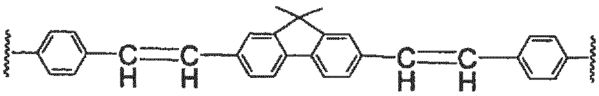

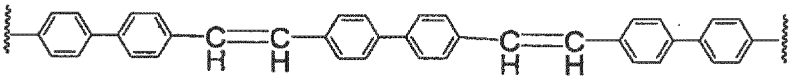

wherein in the formulas, the wavy line at the both ends continue to a nitrogen atom.

The specific examples of the compound represented by the formula (1) are given below.

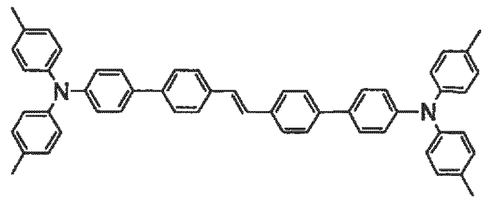

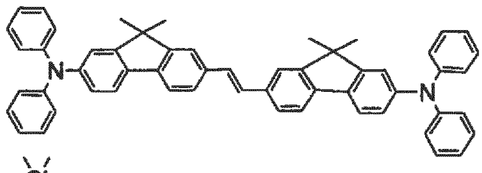

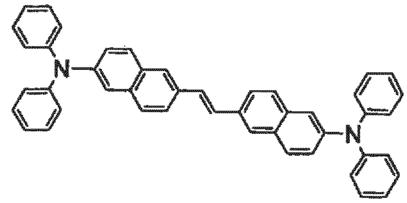

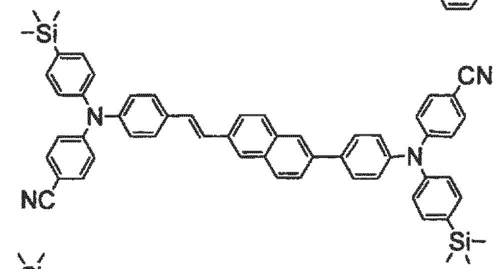

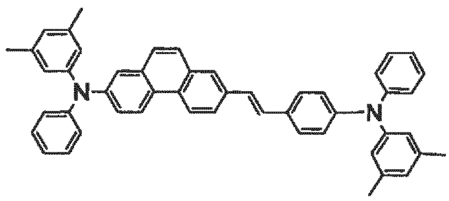

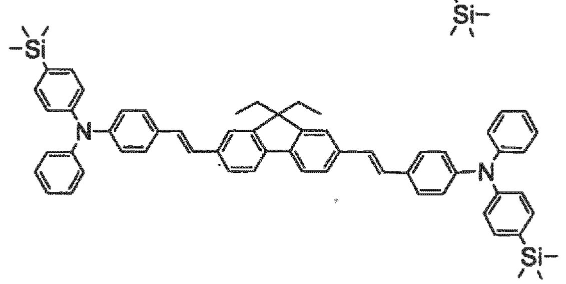

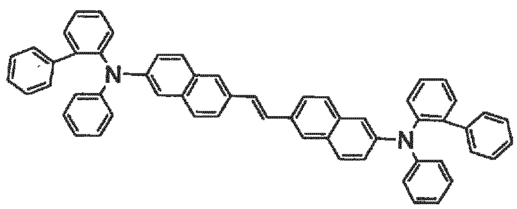

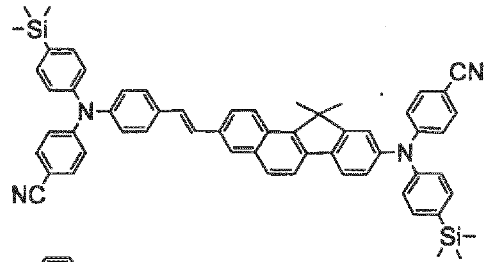

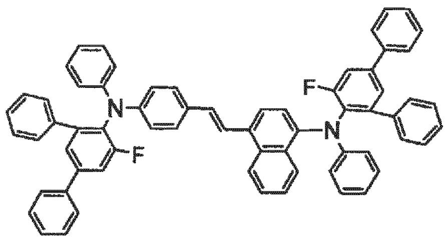

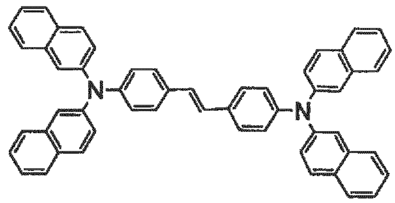

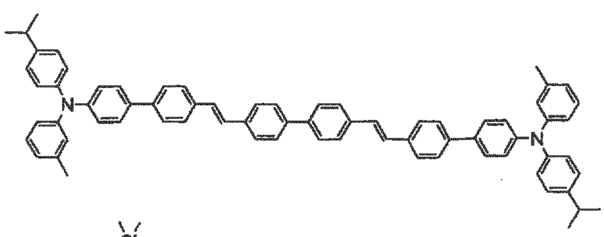

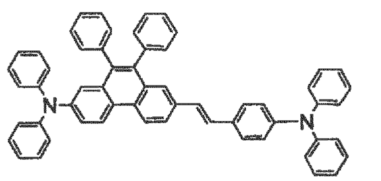

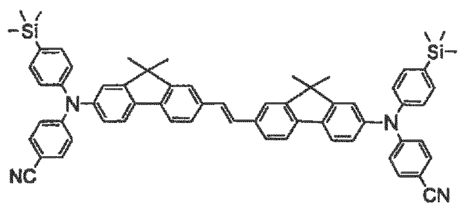

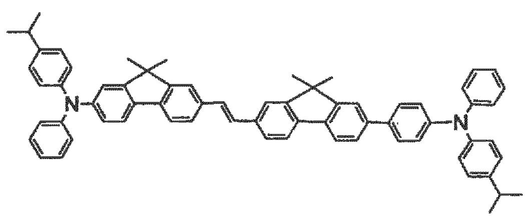

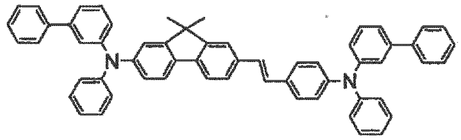

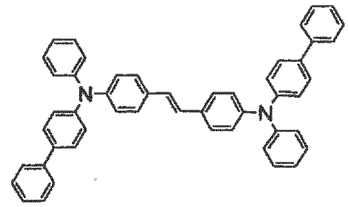

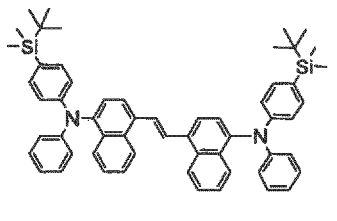

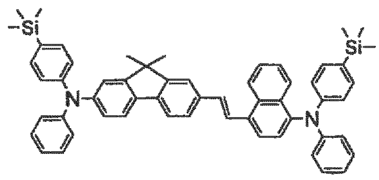

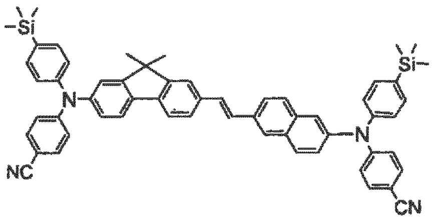

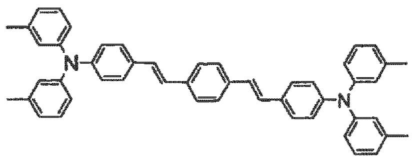

The styrylamine derivative which can be used in the invention is represented by the following formula (2):

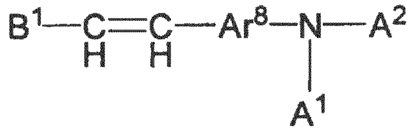

(2)

In the formula (2), $Ar^8$ is a substituted or unsubstituted arylene group or a substituted or unsubstituted heteroarylene group.

$A^1$ and $A^2$ are independently an alkyl group, a substituted or unsubstituted aryl group, a substituted or unsubstituted heteroaryl group or a group represented by the following formula (3):

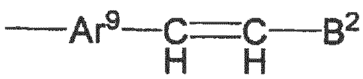

(3)

In the formula (3), $Ar^9$ is a substituted or unsubstituted arylene group or a substituted or unsubstituted heteroarylene group; $B^2$ is a substituted or unsubstituted aryl group or a substituted or unsubstituted heteroaryl group; when $A^1$ and $A^2$ are both groups represented by the formula (3), $Ar^9$ and $B^2$ may be the same or different.

$B^1$ is a substituted or unsubstituted aryl group or a substituted or unsubstituted heteroaryl group.

It is preferred that at least one or more of $Ar^8$ to $Ar^9$ be a substituted or unsubstituted naphthylene group or a substituted or unsubstituted fluorenylene group.

As the alkyl group represented by $A^1$ and $A^2$, an alkyl group having 1 to 10 (preferably 1 to 8, more preferably 1 to 6) carbon atoms can be given. Specific examples thereof include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group and the like.

As the substituted or unsubstituted aryl group represented by $A^1$, $A^2$, $B^1$ and $B^2$, a substituted or unsubstituted aryl group having 6 to 30 (preferably 6 to 20, more preferably 6 to 12) ring carbon atoms. Specific examples thereof include a substituted or unsubstituted phenyl group, a substituted or unsubstituted naphthyl group, a substituted or unsubstituted anthryl group, a substituted or unsubstituted phenanthryl group, a substituted or unsubstituted naphthacenyl group, a substituted or unsubstituted anthracenyl group, a substituted or unsubstituted chrysenyl group, a substituted or unsubstituted fluorenyl group, a substituted or unsubstituted triphenylenyl group, a substituted or unsubstituted pyrenyl group, a substituted or unsubstituted biphenyl group, a substituted or unsubstituted p- terphenyl group, a substituted or unsubstituted m- terphenyl group, a substituted or unsubstituted o- tolyl group, a substituted or unsubstituted m- tolyl group, a substituted or unsubstituted p- tolyl group, a substituted or unsubstituted p- t- butylphenyl group, a substituted or unsubstituted p- (phenylpropyl) phenyl group, a substituted or unsubstituted methylnaphthyl group, a substituted or unsubstituted methylanthryl group, a substituted or unsubstituted methylbiphenyl group, a substituted or unsubstituted t- butyl- p- terphenyl group, a substituted or unsubstituted dimethylfluorenyl group, a substituted or unsubstituted m- biphenyl group, a substituted or unsubstituted o- biphenyl group, a substituted or unsubstituted 4- (2- phenylpropane- 2- yl) phenyl group, a substituted or unsubstituted fluoranthenyl group, a substituted or unsubstituted 9, 9'- dimethylfluorenyl group, a substituted or unsubstituted benzo- 9, 9'- dimethylfluroenyl group, a substituted or unsubstituted dibenzo- 9, 9'- dimethylflureonyl group or the like can be given. An aromatic group formed of a combination of a phenyl group, a phenylene group, a naphthyl group and a naphthalene group (a phenylnaphthyl group, a naphthylphenyl group, a naphthylnaphthyl group, a naphthylnaphthylnaphthyl group, a phenylphenylnaphthyl group, a naphthylnaphthylphenyl group, a naphthylphenylnaphthyl group, a naphthylphenylphenyl group, a phenylnaphthylnaphthyl group, a phenylnaphthylphenyl group or the like) may be used.

Preferably, an aromatic group such as a substituted or unsubstituted phenyl group, a substituted or unsubstituted biphenyl group, a substituted or unsubstituted terphenyl group, a substituted or unsubstituted naphthyl group, a substituted or unsubstituted phenanthryl group, a substituted or unsubstituted anthracenyl group, a substituted or unsubstituted chrysenyl group and a substituted or unsubstituted fluorenyl group can be given.

It is particularly preferred that $A^1$, $A^2$, $B^1$ and $B^2$ be independently a substituted or unsubstituted phenyl group, a substituted or unsubstituted biphenyl group, a substituted or unsubstituted naphthyl group and a substituted or unsubstituted fluorenyl group.

As the substituted or unsubstituted heteroaryl group represented by $A^1$, $A^2$, $B^1$ and $B^2$, a substituted or unsubstituted heteroaryl group having 5 to 30 (preferably 5 to 20, more preferably 5 to 12) ring atoms can be given. Specific examples thereof include a substituted or unsubstituted pyrrolyl group, a substituted or unsubstituted pyrazinyl group, a substituted or unsubstituted pyridinyl group, a substituted or unsubstituted indolyl group, a substituted or unsubstituted isoindolyl group, a substituted or unsubstituted furyl group, a substituted or unsubstituted benzofuranyl group, a substituted or unsubstituted dibenzofuranyl group, a substituted or unsubstituted isobenzofuranyl group, a substituted or unsubstituted quinolyl group, a substituted or unsubstituted isoquinolyl group, a substituted or unsubstituted quinoxalinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted phenothiazinyl group, a substituted or unsubstituted phenoxadinyl group, a substituted or unsubstituted oxazolyl group, a substituted or unsubstituted oxadiazolyl group, a substituted or unsubstituted frazanyl group, a substituted or unsubstituted thienyl group, a substituted or unsubstituted methylpyrrolyl group, a substituted or unsubstituted t-butylpyrrolyl group, a substituted or unsubstituted (phenylpropyl)pyrrolyl group, a substituted or unsubstituted methylindolyl group, a substituted or unsubstituted t-butylindolyl group, a substituted or unsubstituted dibenzothiophenyl group, a substituted or unsubstituted pyrimidinyl group, and a substituted or unsubstituted pyridazinyl group.

A substituted or unsubstituted dibenzofuranyl group, a substituted or unsubstituted pyridinyl group and a substituted or unsubstituted carbazolyl group are preferable.

One in which $A^1$ and $A^2$ are independently a substituted or unsubstituted dibenzofuranyl group is particularly preferable.

As the substituted or unsubstituted arylene group represented by $Ar^8$ and $Ar^9$, a divalent group of the substituted or unsubstituted aryl group represented by $A^1$, $A^2$, $B^1$ and $B^2$ can be given.

An aromatic group such as a substituted or unsubstituted phenylene group, a substituted or unsubstituted biphenylene group, a substituted or unsubstituted terphenylene group, a substituted or unsubstituted naphthylene group, a substituted or unsubstituted phenanthrenylene group, a substituted or unsubstituted anthracenylene group, a substituted or unsubstituted chrysenylene group, a substituted or unsubstituted fluolenylene group and a substituted or unsubstituted triphenylenylene group or the like can preferably be given.

As the substituted or unsubstituted arylene group represented by $Ar^8$ and $Ar^9$, the following groups can be given.

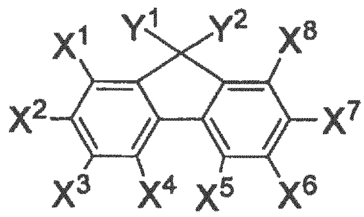

In the formula, $Y^1$, $Y^2$ and $X^1$ to $X^8$ are a hydrogen atom, an alkyl group, a cycloalkyl group, a substituted or unsubstituted aryl group or a substituted silyl group. $X^1$ and $X^2$, $X^2$ and $X^3$, $X^3$ and $X^4$, $X^5$ and $X^6$, $X^6$ and $X^7$, and $X^7$ and $X^8$ are bonded with each other to form a saturated or unsaturated ring structure shown below. The ring structure may further have a substituent However, if a ring structure is formed, any two selected from $X^1$ to $X^8$ and the bonding parts of the ring structure are bonded as a single bond.

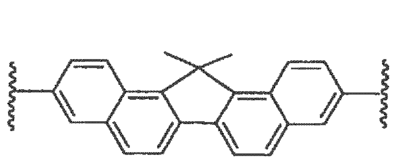

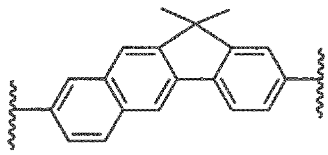

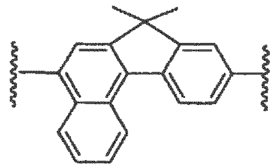

wherein in the formulas, the wavy line at the both ends continue to a bonding part as a single bond.

As the substituted or unsubstituted heteroarylene group represented by $Ar^8$ and $Ar^9$, a divalent group of the substituted or unsubstituted heteroaryl group represented by $A^1$, $A^2$, $B^1$ and $B^2$ can be given.
A substituted or unsubstituted dibenzofuranylene group, a substituted or unsubstituted pyridinylene group and a substituted or unsubstituted carbazolylene group are preferable.

The substituents of $Ar^8$, $Ar^9$, $A^1$, $A^2$, $B^1$ and $B^2$ are the same as those for $Ar^1$ to $Ar^7$.

The specific examples of the compounds represented by the formula (2) are given below.

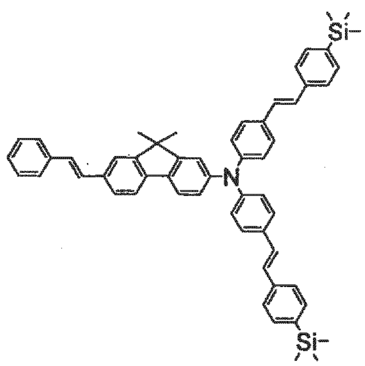

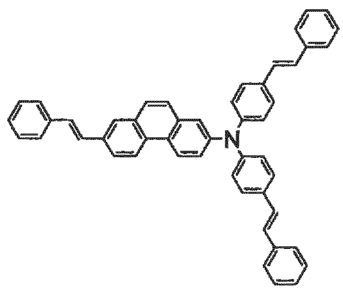

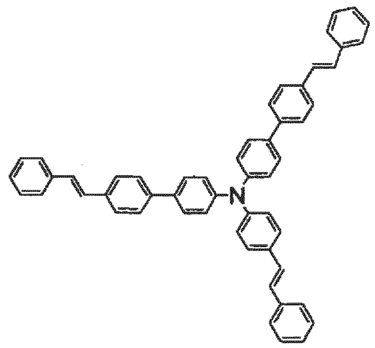

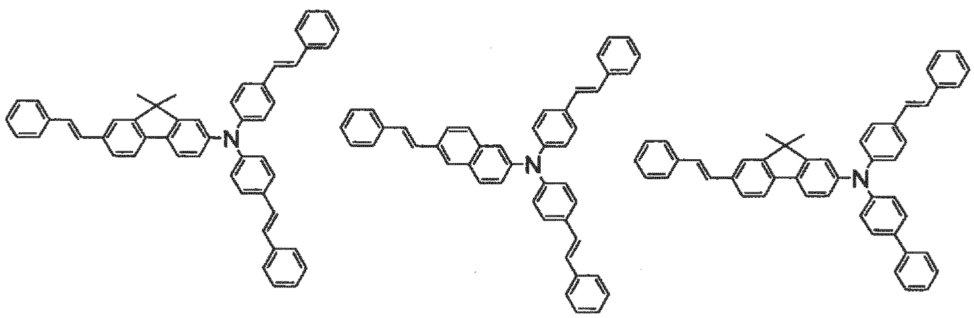

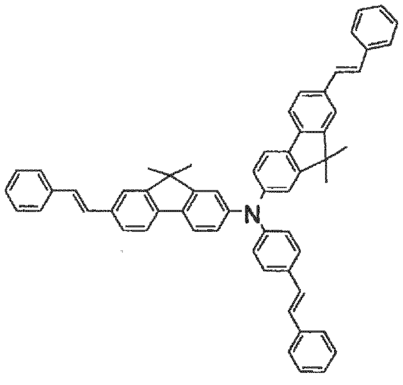

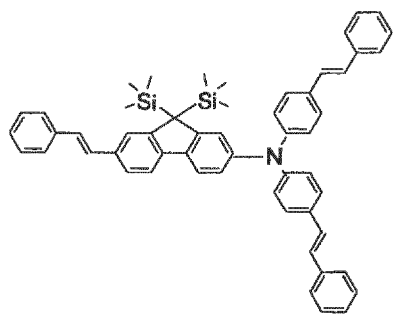

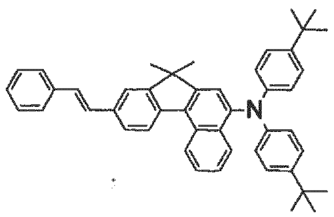

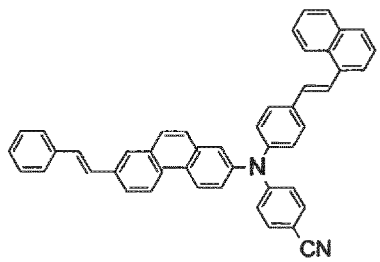

As the host, the anthracene derivative represented by the following formula (10) is preferable.

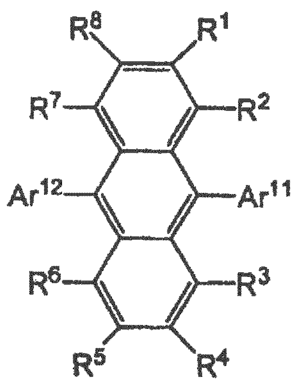

(10)

In the formula (10), $Ar^{11}$ and $Ar^{12}$ are independently a substituted or unsubstituted aryl group having 6 to 50 ring carbon atoms or a substituted or unsubstituted heterocyclic group having 5 to 50 ring atoms, and

$R^1$ to $R^8$ are independently a group selected from a hydrogen atom, a substituted or unsubstituted aryl group having 6 to 50 ring carbon atoms, a substituted or unsubstituted heterocyclic ring having 5 to 50 ring atoms, a substituted or unsubstituted alkyl group having 1 to 50 ring atoms, a substituted or unsubstituted cycloalkyl group having 3 to 50 ring carbon atoms, a substituted or unsubstituted alkoxy group having 1 to 50 carbon atoms, a substituted or unsubstituted aralkyl group having 7 to 50 carbon atoms, a substituted or unsubstituted aryloxy group having 6 to 50 ring carbon atoms, a substituted or unsubstituted arylthio group having 6 to 50 ring carbon atoms, a substituted or unsubstituted alkoxycarbonyl group having 2 to 50 carbon atoms, a substituted or unsubstituted silyl group, a carboxyl group, a halogen atom, a cyano group, a nitro group and a hydroxyl group.

It is preferred that the anthracene derivative according to the invention be any of the following anthracene derivatives (A), (B) and (C). A suitable anthracene derivative is selected according the configuration or required properties of an organic EL device to which it is applied.

(Anthracene derivative (A))

In the anthracene derivative represented by the formula (10), it is preferred that $Ar^{11}$ and $Ar^{12}$ be independently a substituted or unsubstituted fused aryl ring group having 10 to 50 ring carbon atoms. This anthracene derivative can

be divided into an anthracene derivative in which $Ar^{11}$ and $Ar^{12}$ are the same substituted or unsubstituted fused aryl group and an athracene derivative in which $Ar^{11}$ and $Ar^{12}$ are different substituted or unsubstituted fused aryl groups. Specifically, anthracene derivatives represented by the following formulas (2-1) to (2-3) and anthracene derivatives represented by the formula (10) in which $Ar^{11}$ and $Ar^{12}$ are different substituted or unsubstituted fused aryl groups can be given.

In the anthracene derivative represented by the following formula (2-1), $Ar^{11}$ and $Ar^{12}$ are a substituted or unsubstituted 9-phenanthrenyl group.

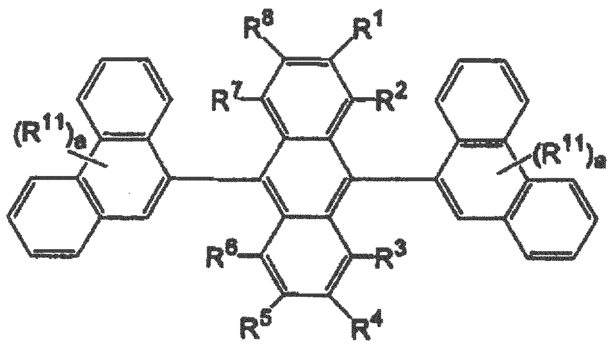

(2-1)

In the formula (2-1), $R^1$ to $R^8$ are as defined above,
$R^{11}$ is a group selected from a hydrogen atom, a substituted or unsubstituted aryl group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted cycloalkyl group having 3 to 50 ring carbon atoms, a substituted or unsubstituted alkoxy group having 1 to 50 carbon atoms, a substituted or unsubstituted aralykyl group having 7 to 50 carbon atoms, a substituted or unsubstituted aryloxy group having 6 to 50 ring carbon atoms, a substituted or unsubstituted arylthio group having 6 to 50 ring carbon atoms, a substituted or unsubstituted alkoxycarbonyl group having 2 to 50 carbon atoms, a substituted or unsubstituted silyl group, a carboxyl group, a halogen atom, a cyano group, a nitro group and a hydroxyl group.
a is an integer of 0 to 9, and when a is an integer of 2 or more, plural $R^{11}$s may be the same or different on the condition that the two substituted or unsubstituted phenanthrenyl groups are the same.

The anthracene derivative represented by the following formula (2-2) is an anthracene derivative represented by the formula (10) in which $Ar^{11}$ and $Ar^{12}$ are a substituted or unsubstituted 2-naphthyl group.

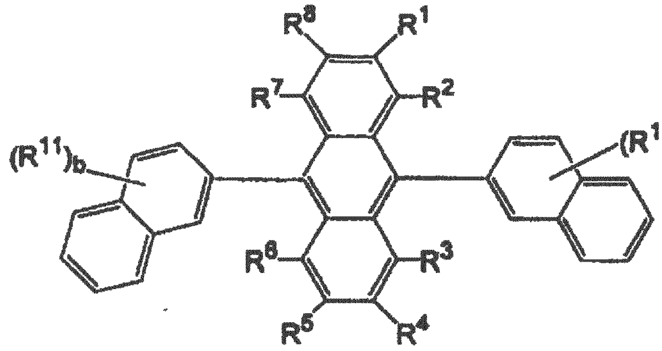

(2-2)

In the formula (2-2), $R^1$ to $R^8$ and $R^{11}$ are as defined above, b is an integer of 1 to 7. If b is an integer of 2 or more, plural $R^{11}$s may be the same or different on the condition that the two substituted or unsubstituted 2-naphthyl groups are the same.

The anthracene derivative represented by the following formula (2-3) is an anthracene derivative represented by the formula (10) in which $Ar^{11}$ and $Ar^{12}$ are a substituted or unsubstituted 1-naphthyl group.

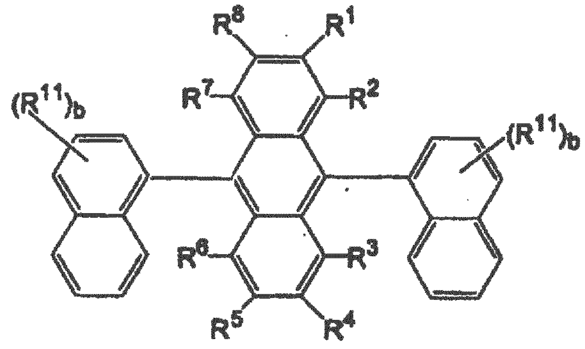

(2-3)

In the formula (2-3), $R^1$ to $R^8$, $R^{11}$ and b are as defined above. If b is an integer of 2 or more, plural $R^{11}$s may be the same or different on the condition that the two substituted or unsubstituted 1-naphthyl groups are the same.

As for the anthracene derivative represented by the formula (10) in which $Ar^{11}$ and $Ar^{12}$ are different substituted or unsubstituted fused aryl groups, it is preferred that $Ar^{11}$ and $Ar^{12}$ be a substituted or unsubstituted 9-phenanthrenyl group, a substituted or unsubstituted 1-naphthyl group or a substituted or unsubstituted 2-naphthyl group.
Specifically, this anthracene derivative is divided into one in which $Ar^{11}$ is a 1-naphthyl group and $Ar^{12}$ is a 2-naphthyl group, one in which $Ar^{11}$ is a 1-naphthyl group and $Ar^{12}$ is a 9-phenanthryl group, and one in which $Ar^{11}$ is a 2-naphthyl group and $Ar^{12}$ is a 9-phenanthryl group.

(Anthracene derivative (B))

This anthracene derivative is an anthracene derivative in which one ofAr" and $Ar^{12}$ in the formula (10) is a substituted or unsubstituted phenyl group, and the other is a substituted or unsubstituted fused aryl group having 10 to 50 ring carbon atoms. Specific examples of the anthracene derivative include anthracene derivatives represented by the following formulas (2-4) and (2-5).

In the anthracene derivative represented by the following formula (2-4), $Ar^{11}$ in the formula (10) is a substituted or unsubstituted 1-naphthyl group and $Ar^{12}$ in the formula (10) is a substituted or unsubstituted phenyl group.

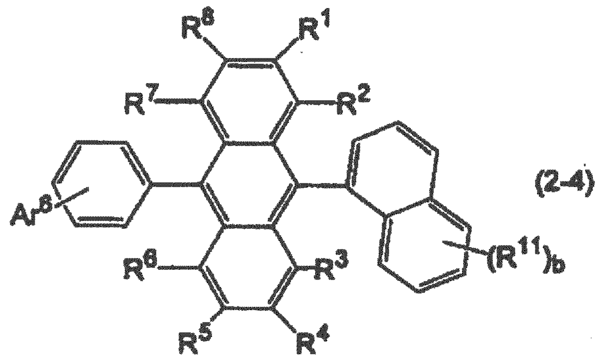

(2-4)

In the formula (2- 4), $R^1$ to $R^8$ and $R^{11}$ and b are as defined above,
$Ar^6$ is a substituted or unsubstituted aryl group having 6 to 50 ring carbon atoms, a substituted or unsubstituted alkyl group having 1 to 50 carbon atoms, a substituted or unsubstituted cycloalkyl group having 3 to 50 ring carbon atoms, a substituted or unsubstituted aralkyl group having 7 to 50 carbon atoms, a substituted or unsubstituted heterocyclic group having 5 to 50 ring atoms, a 9, 9- dimethylfluorene- 1- yl group, a 9, 9- dimethylfluorene- 2- yl group, a 9, 9- dimethylfluorene- 3- yl group, a 9, 9- dimethylfluorene- 4- yl group, a dibenzofuran- 1- yl group, a dibenzofuran- 2- yl group, a dibenzofuran- 3- yl group or a dibenzofuran- 4- yl group. $Ar^6$ may form, together with the benzene ring to which it bonds, a ring such as a substituted or unsubstituted fluorenyl group or a substituted or unsubstituted dibenzofuranyl group, or the like. If b is an integer of 2 or more, plural $R^{11}$s may be the same or different.

The anthracene derivative represented by the following formula (2-5) is an anthracene derivative in which $Ar^{11}$ in the formula (10) is a substituted or unsubstituted 2-naphthyl group and $Ar^{12}$ in the formula (10) is a substituted or unsubstituted phenyl group.

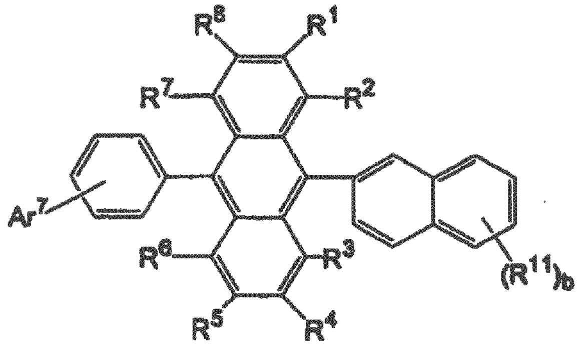

(2-5)

In the formula (2-5), $R^1$ to $R^8$, $R^{11}$ and b are as defined above,
$Ar^7$ is a substituted or unsubstituted aryl group having 6 to 50 ring carbon atoms, a substituted or unsubstituted heterocyclic group having 5 to 50 ring atoms, a substituted or unsubstituted alkyl group having 1 to 50 carbon atoms, a substituted or unsubstituted cycloalkyl group having 3 to 50 ring carbon atoms, a substituted or unsubstituted aralkyl group having 7 to 50 carbon atoms, a dibenzofuran-1-yl group, a dibenzofuran-2-yl group, a dibenzofuran-3-yl group or a dibenzofuran-4-yl group. $Ar^7$ may form, together with the benzene ring to which it bonds, a ring such as a substituted or unsubstituted fluorenyl group or a substituted or unsubstituted dibenzofuranyl group. If b is an integer of 2 or more, plural $R^{11}$s may be the same or different

(Anthracene derivative (C))

This anthracene derivative is represented by the following formula (2-6). Specifically, it is preferred that the anthracene derivative be a derivative represented by any of the following formulas (2-6-1), (2-6-2) and (2-6-3).

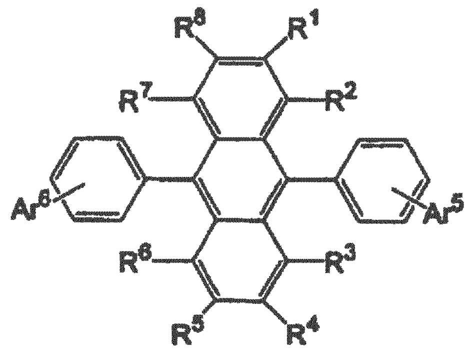

(2-6)

In the formula (2-6), $R^1$ to $R^8$ and $Ar^6$ are as defined above.
$Ar^5$ is a substituted or unsubstituted aryl group having 6 to 50 ring carbon atoms, a substituted or unsubstituted alkyl group having 1 to 50 carbon atoms, a substituted or unsubstituted cycloalkyl group having 3 to 50 ring carbon atoms, a substituted or unsubstituted aralkyl group having 7 to 50 carbon atoms or a substituted or unsubstituted heterocyclic group having 5 to 50 ring atoms, and $Ar^5$ and $Ar^6$ are independently selected.

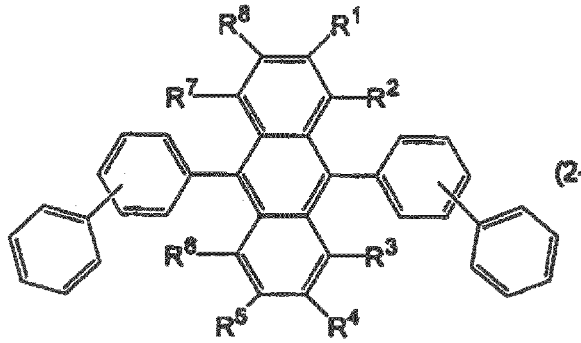

(2-6-1)

In the formula (2-6-1), $R^1$ to $R^8$ are as defined above.

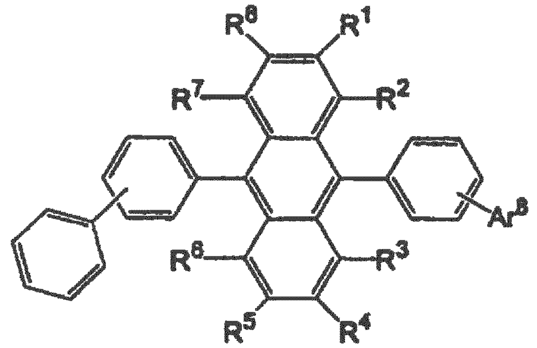

(2-6-2)

In the formula (2-6-2), $R^1$ to $R^8$ are as defined above. $Ar^8$ is a substituted or unsubstituted fused aryl group having 10 to 20 ring carbon atoms.

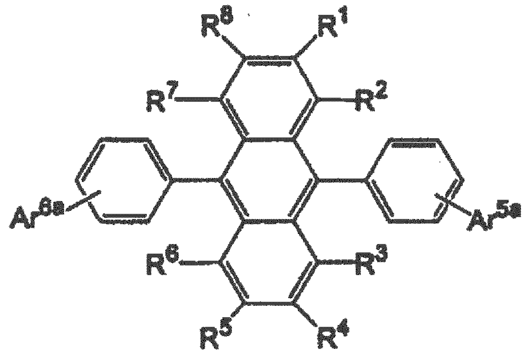

(2-6-3)

In the formula (2-6-3), $R^1$ to $R^8$ are as defined in the formula (10).
$Ar^{5a}$ and $Ar^{6a}$ are independently a substituted or unsubstituted fused aryl group having 10 to 20 ring carbon atoms.

As the substituted or unsubstituted aryl group having 6 to 50 ring carbon atoms represented by $R^1$ to $R^8$, $R^{11}$, $Ar^5$ to $Ar^7$, $Ar^{11}$ and $Ar^{12}$, a phenyl group, a 1- naphthyl group, a 2- naphthyl group, a 1- anthryl group, a 2- anthryl group, a 9- anthryl group, a 1- phenanthryl group, a 2- phenanthryl group, a 3- phenanthryl group, a 4- phenanthryl group, a 9- phenanthryl group, a 1- naphthacenyl group, a 2- naphthacenyl group, a 9- naphthacenyl group, a 1- pyrenyl group, a 2- pyrenyl group, a 4- pyrenyl group, a 6- chrysenyl group, a 1- benzo [c] phenanthryl group, a 2- benzo [c] phenanthryl group, a 3- benzo [c] phenanthryl group, a 4- benzo [c] phenanthryl group, a 5- benzo [c] phenanthryl group, a 6- benzo [c] phenanthryl group, a 1- benzo [g] chrysenyl group, a 2- benzo [g] chrysenyl group, a 3- benzo [g] chrysenyl group, a 4- benzo [g] chrysenyl group, a 5- benzo benzo [g] chrysenyl group, a 6- benzo [g] chrysenyl group, a 7- benzo [g] chrysenyl group, a 8- benzo [g] chrysenyl group, a 9- benzo [g] chrysenyl group, a 10- benzo [g] chrysenyl group, a 11- benzo [g] chrysenyl group, a 12- benzo [g] chrysenyl group, a 13- benzo [g] chrysenyl group, a 14- benzo [g] chrysenyl group, a 1- triphenyl group, a 2- triphenyl group, a 2- fluorenyl group, a 9, 9- dimethylfluorene- 2- yl group, a benzofluorenyl group, a dibenzofluorenyl group, a 2- biphenylyl group, a 3- biphenylyl group, a 4- biphenylyl group, a p- terphenyl- 4- yl group, a p- terphenyl- 3- yl group, a p- terphenyl- 2- yl group, a m- terphenyl- 4- yl group, a m- terphenyl- 3- yl group, a m- terphenyl- 2- yl group, a o- tolyl group, a m- tolyl group, a p- tolyl group, a p- t- butylphenyl group, p- (2- phenylpropyl) phenyl group, a 3- methyl- 2- naphthyl group, a 4- methyl- 1- naphthyl group, a 4- methyl- 1- anthryl group, a 4'- methylbiphenylyl group, and a 4"- t- butyl- p- terphenyl- 4- yl group or the like can be given. Of these, an unsubstituted phenyl group, a substituted phenyl group and a substituted or unsubstituted aryl group having 10 to 14 ring carbon atoms (a 1- naphthyl group, a 2- naphthyl group and a 9- phenanthryl group, for example), a substituted or unsubstituted fluorenyl group (2- fluorenyl group), a substituted or unsubstituted pyrenyl group (a 1- pyrenyl group, a 2- pyrenyl group, a 4- pyrenyl group) and the like are preferable.

As the substituted or unsubstituted fused aryl group having 10 to 20 ring carbon atoms represented by $Ar^{5a}$, $Ar^{6a}$ and $Ar^8$, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, a 1-naphthacenyl group, a 2-naphthacenyl group, a 9-naphthacenyl group, a 1-pyrenyl group, a 2-pyrenyl group, a 4-pyrenyl group, a 2-fluorenyl group or the like can be given. In particular, a 1-naphthyl group, a 2-naphthyl group, a 9-phenanthryl

group and a fluorenyl group (2-fluorenyl group) are preferable.

As the substituted or unsubstituted heterocyclic group having 5 to 50 ring atoms represented by $R^1$ to $R^8$, $R^{11}$, $Ar^5$ to $Ar^7$, $Ar^{11}$ and $Ar^{12}$, a 1- pyrrolyl group, a 2- pyrrolyl group, a 3- pyrrolyl group, a pyrazinyl group, a 2- pyridinyl group, a 3- pyridinyl group, a 4- pyridinyl group, a 1- indolyl group, a 2- indolyl group, a 3- indolyl group, a 4- indolyl group, a 5- indolyl group, a 6- indolyl group, a 7- indolyl group, a 1- isoindolyl group, a 2- isoindolyl group, a 3- isoindolyl group, a 4- isoindolyl group, a 5- isoindolyl group, a 6- isoindolyl group, a 7- isoindoly group, a 2- furyl group, a 3- furyl group, a 2- benzofuranyl group, a 3- benzofuranyl group, a 4- benzofuranyl group, a 5- benzofuranyl group, a 6- benzofuranyl group, a 7- benzofuranyl group, a 1- isobenzofuranyl group, a 3- isobenzofuranyl group, a 4- isobenzofuranyl group, a 5- isobenzofuranyl group, a 6- isobenzofuranyl group, a 7- isobenzofuranyl group, a 1- dibenzoisofuranyl group, a 2- dibenzofuranyl group, a 3- dibenzofuranyl group, a 4- dibenzofuranyl group, a 1- dibenzothiophenyl group, a 2- dibenzothiophenyl group, a 3- dibenzothiophenyl group, a 4- dibenzothiophenyl group, a quinolyl group, a 3- quinolyl group, a 4- quinolyl group, a 5- quinolyl group, a 6- quinolyl group, a 7- quinolyl group, a 8- quinolyl group, a 1- isoquinolyl group, a 3- isoquinolyl group, a 4- isoquinolyl group, a 5- isoquinolyl group, a 6- isoquinolyl group, a 7- isoquinolyl group, a 8- isoquinolyl group, a 2- quinoxalynyl group, a 5- quinoxalynyl group, a 6- quinoxalynyl group, a 1- carbazolyl group, a 2- carbazolyl group, a 3- carbazolyl group, a 4- carbazolyl group, a 9- carbazolyl group, a 1- phenanthridinyl group, a 2- phenanthridinyl group, a 3- phenanthridinyl group, a 4- phenanthridinyl group, a 6- phenanthridinyl group, a 7- phenanthridinyl group, a 8- phenanthridinyl group, a 9- phenanthridinyl group, a 10- phenanthridinyl group, a 1- acridinyl group, a 2- acridinyl group, a 3- acridinyl group, a 4- acridinyl group, a 9- acridinyl group, a 1, 7- phenanthroline- 2- yl group, a 1, 7- phenanthroline- 3- yl group, a 1, 7- phenanthroline- 4- yl group, a 1, 7- phenanthroline- 5- yl group, a 1, 7- phenanthroline- 6- yl group, a 1, 7- phenanthroline- 8- yl group, a 1, 7- phenathroline- 9- yl group, a 1, 7- phenanthroline- 10- yl group, a 1, 8- phenanthroline- 2- yl group, a 1, 8- phenanthroline- 3- yl group, a 1, 8- phenanthroline- 4- yl group, a 1, 8- phenanthroline- 5- yl group, a 1, 8- phenanthroline- 6- yl group, a 1, 8- phenanthroline- 7- yl group, a 1, 8- phenanthroline- 9- yl group, a 1, 8- phenanthroline- 10- yl group, a 1, 9- phenanthroline- 2- yl group, a 1, 9- phenathroline- 3- yl group, a 1, 9- phenanthroline- 4- yl group, a 1, 9- phenanthroline- 5- yl group, a 1, 9- phenanthroline- 6- yl group, a 1, 9- phenathroline- 7- yl group, a 1, 9- phenanthroline- 8- yl group, a 1, 9- phenantholine- 10- yl group, 1, 10- phenanthroline- 2- yl group, a 1, 10- phenanthroline- 3- yl group, a 1, 10- phenanthroline- 4- yl group, a 1, 10- phenanthorline- 5- yl group, a 2, 9- phenanthroline- 1- yl group, a 2, 9- phenanthroline- 3- yl group, a 2, 9- phenanthroline- 4- yl group, a 2, 9- phenanthroline- 5- yl group, a 2, 9- phenanthroline- 6- yl group, a 2, 9- phenanthroline- 7- yl group, a 2, 9- phenanthroline- 8- yl group, a 2, 9- phenantrholine- 10- yl group, a 2, 8- phenanthroline- 1- yl group, a 2, 8- phenanthroline- 3- yl group, a 2, 8- phenanthoroine- 4- yl group, a 2, 8- phenantrholine- 5- yl group, a 2, 8- phenanthrcline- 6- yl group, a 2, 8- phenanthroline- 7- yl group, a 2, 8- phenanthroline- 9- yl group, a 2, 8- phenanthroline- 10- yl group, a 2, 7- phenanthroline- 1- yl group, a 2, 7- phenanthroline- 3- yl group, a 2, 7- phenanthroline- 4- yl group, a 2, 7- phenanthroline- 5- yl group, a 2, 7- phenanthroline- 6- yl group, a 2, 7- phenanthroline- 8- yl group, a 2, 7- phenanthroline- 9- yl group, a 2, 7- phenanthroline- 10- yl group, a 1- phenazinyl group, a 2- phenazinyl group, a 1- phenothiazinyl group, a 2- phenothiazinyl group, a 3- phenothiazinyl group, a 4- phenothiazinyl group, a 10- phenothiazinyl group, a 1- phenoxazinyl group, a 2- phenoxazinyl group, a 3- phenoxazinyl group, a 4- phenoxazinyl group, a 10- phenoxazinyl group, a 2- oxazolyl group, a 4- oxazolyl group, a 5- oxazolyl group, a 2- oxadiazolyl group, a 5- oxadiazolyl group, a 3- furazanyl group, a 2- thienyl group, a 3- thienyl group, a 2- methylpyrrole- 1- yl group, a 2- methylpyrrole- 3- yl group, a 2- methylpyrrole- 4- yl group, a 2- methylpyrrole- 5- yl group, a 3- methylpyrrole- 1- yl group, a 3- methylpyrrole- 2- yl group, a 3- methylpyrrole- 4- yl group, a 3- methylpyrrole- 5- yl group, a 2- t- butylpyrrole- 4- yl group, a 3- (2- phenylpropyl) pyrrole- 1- yl group, a 2- methyl- 1- indolyl group, a 4- methyl- 1- indolyl group, a 2- methyl- 3- indoyl group, a 4- methyl- 3- indolyl group, a 2- t- butyl- 1- indolyl group, a 4- t- butyl- 1- indolyl group, a 2- t- butyl- 3- indolyl group, a 4- t- butyl- 3- indolyl group or the like can be given. Of these, a 1- dibenzofuranyl group, a 2- dibenzofuranyl group, a 3- dibenzofuranyl group, a 4- dibenzofuranyl group, a 1- dibenzothiophenyl group, a 2- dibenzothiophenyl group, a 3- dibenzothiophenyl group, a 4- dibenzothiophenyl group, a 1- carbazolyl group, a 2- carbazolyl group, a 3- carbazolyl group, a 4- carbazolyl group and a 9- carbazolyl group are preferable.

As the substituted or unsubstituted alkyl group having 1 to 50 carbon atoms represented by $R^1$ to $R^8$, $R^{11}$ and $Ar^5$ to $Ar^7$, , a methyl group, an ethyl group, a propyl group, an isopropyl group, an n- butyl group, an s- butyl group, an isobutyl group, a t- butyl group, an n- pentyl group, an n- hexyl group, an n- heptyl group, an n- octyl group, a hydroxymethyl group, a 1- hydroxyethyl group, a 2- hydroxyethyl group, a 2- hydroxyisobutyl group, a 1, 2- dihydroxyethyl group, a 1, 3- dihydroxyisopropyl group, a 2, 3- dihydroxy- t- butyl group, a 1, 2, 3- trihydroxypropyl group, a chloromethyl group, a 1- chloroethyl group, a 2- chloroethyl group, a 2- chloroisobutyl group, a 1, 2- dichlorochloroethyl group, a 1, 3- dichloroisopropyl group, a 2, 3- dichloro- t- butyl group, a 1, 2, 3- trichloropropyl group, a bromomethyl group, a 1- bromoethyl group, a 2- bromoethyl group, a 2- bromoisobutyl group, a 1, 2- dibromoethyl group, a 1, 3- dibromoisopropyl group, a 2, 3- dibromo- t- butyl group, a1, 2, 3- tribromopropyl group, an iodomethyl group, a 1- iodoethyl group, a 2- iodoethyl group, a 2- iodoisobutyl group, a 1, 2- diiodoethylgroup, a 1, 3- diiodoisopropyl group, a 2, 3- diiodo- t- butyl group, a 1, 2, 3- triiodopropyl group, an aminomethyl group, a 1- aminoethylgroup, a 2- aminoethyl group, a 2- aminoisobutyl group, a 1, 2- diaminoethyl group, a 1, 3- diaminoisopropyl group, a 2, 3- diamino- t- butyl group, a 1, 2, 3- triaminopropyl group,

a cyanomethyl group, a 1- cyanoethyl group, a 2- cyanoethyl group, 2- cyanoisobutyl group, a 1, 2- dicyanoethyl group, a 1, 3- dicyanoisopropyl group, a 2, 3- dicyano- t- butyl group, a 1, 2, 3- tricyanopropyl group, a nitromethyl group, 1- nitroethyl group, a 2- nitoroethyl group, a 2- nitoroisobutyl group, a 1, 2- dinitroethyl group, a 1, 3- dinitroisopropyl group, a 2, 3- dinitro- t- butyl group, a 1, 2, 3- trinitropropyl group or the like can be given. Of these, a methyl group, an ethyl group, a propyl group, an isopropyl group, an n- butyl group, an s- butyl group, an isobutyl group and a t- butyl group are preferable.

As the substituted or unsubstituted cycloalkyl group having 3 to 50 ring carbon atoms represented by $R^1$ to $R^8$, $R^{11}$ and $Ar^5$ to $Ar^7$, a cyclopropyl group, a cyclobutyl group, a cyclopentyl group, a cyclohexyl group, a 4-methylcyclohexyl group, a 1-adamantyl group, a 2-adamantyl group, a 1-norbomyl group, a 2-norbomyl group or the like can be given. Of these, a cyclopentyl group and a cyclohexyl group are preferable.

The substituted or unsubstituted alkoxy group having 1 to 50 carbon atoms represented by $R^1$ to $R^8$ and $R^{11}$ having 1 to 50 carbon atoms is a group represented by -OZ. Z is selected from the substituted or unsubstituted alkyl group having 1 to 50 carbon atoms represented by $R^1$ to $R^8$.

Examples of the substituted or unsubstituted aralkyl group having 7 to 50 carbon atoms (the aryl part having 6 to 49 carbon atoms and the alkyl part having 1 to 44 carbon atoms) of the substituents of $R^1$ to $R^8$, $R^{11}$ and $Ar^5$ to $Ar^7$ include benzyl, 1- phenylethyl, 2- phenylethyl, 1- phenylisopropyl, 2- phenylisopropyl, phenyl- t- butyl, α- naphthylmethyl, 1- α- naphthylethyl, 2- α- naphthylethyl, 1- α- naphthylisopropyl, 2- α- naphthylisopropyl, β- naphthylmethyl, 1- β- naphthylethyl, 2- β- naphthylethy, 1- β- naphthylisopropyl, 2- β- naphthylisopropyl, 1- pyrrolylmethyl, 2- (1- pyrrolyl) ethyl, p-methylbenzyl, m- methylbenzyl, o- methylbenzyl, p- chlorobenzyl, m- chlorobenzyl, o- chlorobenzyl, p- bromobenzyl, m-bromobenzyl, o- bromobenzyl, p- iodobenzyl, m- iodobenzyl, o- iodobenzyl, p- hydroxybenzyl, m- hydroxybenzyl, o-hydroxybenzyl, p- aminobenzyl, m- aminobenzyl, o- aminobenzyl, p- nitrobenzyl, m- nitrobenzyl, o- nitrobenzyl, p- cyanobenzyl, m- cyanobenzyl, o- cyanobenzyl, 1- hydroxy- 2- phenylisopropyl, and 1- chloro- 2- phenylisopropyl.

The substituted or unsubstituted aryloxy group and the arylthio group having 6 to 50 ring carbon atoms represented by $R^1$ to $R^8$ and $R^{11}$ are respectively represented by -OY and -SY Y is selected from the substituted or unsubstituted aryl group having 6 to 50 ring carbon atoms represented by $R^1$ to $R^8$.

The substituted or unsubstituted alkoxycarbonyl group having 2 to 50 carbon atoms (the alkyl part has 1 to 49 carbon atoms) represented by $R^1$ to $R^8$ and $R^{11}$ represented by -COOZ and Z is selected from the above-mentioned substituted or unsubstituted alkyl group having 1 to 50 carbon atoms represented by $R^1$ to $R^8$.

As the substituted silyl group represented by $R^1$ to $R^8$ and $R^{11}$, a trimethylsilyl group, a triethylsilyl group, a t-butyldimethylsilyl group, a vinyldimethylsilyl group, a propyldimethylsilyl group, a triphenylsilyl group or the like can be given.

As the halogen atom represented by $R^1$ to $R^8$ and $R^{11}$, fluorine, chlorine, bromine, iodine or the like can be given.

A blocking layer is a layer having a function of preventing diffusion of triplet excitons generated in the emitting layer to the electron-transporting region and injecting electrons efficiently to the emitting layer. If the electron-injection property to the emitting layer is lowered, the density of triplet excitons is reduced due to the decrease of the electron-hole recombination in the emitting layer. If the density of the triplet excitons is decreased, frequency of the collision of the triplet excitons is reduced, and as a result, a TTF phenomenon does not occur efficiently. In respect of efficient injection of electrons to the emitting layer, the following two can be conceived as the morphology of the electron-transporting region including the blocking layer.

(1) Allowing the electron- transporting region to be a stack structure of two or more different materials, and providing an electron- injecting layer for receiving efficiently electrons from the cathode between the blocking layer and the cathode. As the specific examples of the electron- injecting layer, a nitrogen- containing heterocyclic derivative or the like can be given.

(2) Allowing the electron- transporting region to be formed of a single layer of a blocking layer. In this case, in order to facilitate receiving of electrons from the cathode, a donar represented by an alkali metal is doped in the vicinity of the cathode interface in the blocking layer. As the donar, at least one selected from a donar metal, a donar metal compound and a donar metal complex can be selected.

A donar metal means a metal having a work function of 3.8 eV or less. A preferable donar metal includes an alkaline metal, an alkaline earth metal and a rare earth metal. Cs, Li, Na, Sr, K, Mg, Ca, Ba, Yb, Eu and Ce are preferable. A donar metal compound includes a compound containing the above-mentioned donar metal. The donar metal compound is preferably a compound containing an alkali metal, an alkaline earth metal or a rare earth metal. A halide, an oxide, a carbonate and a borate of these metals are more preferable. For example, a compound represented by MOx (M is a donar metal and x is 0.5 to 1.5), MFx (x is 1 to 3), M $(CO_3)$x (x is 0.5 to 1.5) is preferable.

The donar metal complex is a complex of the above- mentioned donar metal. An organic metal complex of an alkaline metal, an alkaline earth metal or a rare earth metal is preferable. An organic metal complex represented by the following formula (I) is preferable.

$$M \{Q)_n \qquad (I)$$

wherein M is a donar metal; Q is a ligand (preferably a carboxylic acid derivative, a diketone derivative or a quinoline derivative; and n is an integer of 1 to 4) .

Specific examples of the donar metal complex include water- mill shaped tungsten or the like stated in JP- A-2005- 72012. Further, a phthalocyanine compound in which the central metal is an alkali metal or an alkaline rare earth metal disclosed in JP- A- H11- 345687 or the like can be used as the donar metal complex.

The above- mentioned donars may be used alone or in combination of two or more.

In the invention, the density of excitons in the interface between the emitting layer and the blocking layer is large. In this case, a possibility is increased that holes which do not contribute to the recombination in the emitting layer will be injected to the blocking layer. Therefore, as the material for the blocking layer, a material having excellent oxidation durability is preferable.

As the specific examples of the material having excellent oxidation durability, an aromatic hydrocarbon compound, in particular, one or more compounds selected from the polycyclic aromatic compounds represented by the following formulas (A), (B) and (C) described in Japanese Patent Application No. 2009- 090379 are desirable.

$$Ra\text{-}Ar^{101}\text{-}Rb \quad (A)$$

$$Ra\text{-}Ar^{101}\text{-}Ar^{102}\text{-}Rb \quad (B)$$

$$Ra\text{-}Ar^{101}\text{-}Ar^{102}\text{-}Ar^{103}\text{-}Rb \quad (C)$$

In the formulas, $Ar^{101}$, $Ar^{102}$, $Ar^{103}$, Ra and Rb are independently a substituted or unsubstituted benzene ring or a polycyclic aromatic skeleton part selected from a substituted or unsubstituted naphthalene ring, a substituted or unsubstituted chrysene ring, a substituted or unsubstituted fluoranthrene ring, a substituted or unsubstituted phenanthrene ring, a substituted or unsubstituted benzophenanthrene ring, a substituted or unsubstituted dibenzophenanthrene ring, a substituted or unsubstituted triphenylene ring, a substituted or unsubstituted benzo[a]triphenylene ring, a substituted or unsubstituted benzochrysene ring, a substituted or unsubstituted benzo[b]fluoranthene ring, a substituted or unsubstituted fluorene ring and a polycyclic aromatic skeleton part selected from a substituted or unsubstituted picene ring, provided that the substituents of Ra and Rb are not an aryl group, and $Ar^1$, $Ar^2$, $Ar^3$, Ra and Rb are not simultaneously a substituted or unsubstituted benzene ring.

In the above-mentioned polycyclic aromatic compound, it is preferred that one of or both of Ra and Rb be selected from a substituted or unsubstituted phenanthrene ring, a substituted or unsubstituted benzo[c]fluoranthene ring and a substituted or unsubstituted fluoranthene ring.

The polycyclic aromatic skeleton part of the polycyclic aromatic compound may have a substituent.

As the examples of the substituent of the polycyclic skeleton part, a halogen atom, a hydroxyl group, a substituted or unsubstituted amino group, a nitro group, a cyano group, a substituted or unsubstituted alkyl group, a substituted or unsubstituted alkenyl group, a substituted or unsubstituted cycloalkyl group, a substituted or unsubstituted alkoxy group, a substituted or unsubstituted aromatic hydrocarbon group, a substituted or unsubstituted aromatic heterocyclic group, a substituted or unsubstituted aralkyl group, a substituted or unsubstituted aryloxy group, a substituted or unsubstituted alkoxycarbonyl group or a carboxyl group can be given. Preferable examples of the aromatic hydrocarbon group include naphthalene, phenanthrene, fluorene, chrysene, fluoranthene and triphenylene.

If the polycyclic aromatic skeleton parts have a plurality of substituents, they may form a ring.

As for the skeleton part, it is preferred that it be any one selected from the group consisting of the compounds represented by the following formulas (1) to (4):

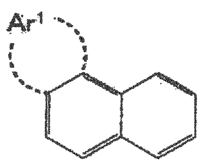

··· (1)

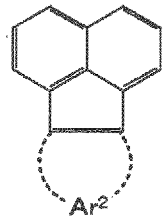

··· (2)

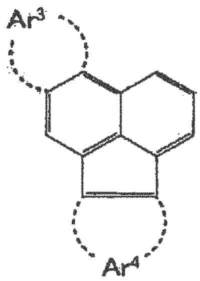

··· (3)

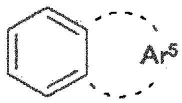

··· (4)

In the formulas (1) to (4), $Ar^1$ to $Ar^5$ each represent a substituted or unsubstituted fused ring structure having 4 to 16 ring carbon atoms.

As the compound represented by the formula (1), a simple body or a derivative of a substituted or unsubstituted phenanthrene or chrysene or the like can be given.

As the compound represented by the formula (2), a simple body or a derivative of a substituted or unsubstituted acenaphthalene, acenaphthene and fluoranthene or the like can be given.

As the compound represented by the formula (3), a simple body or a derivative of a substituted or unsubstituted benzofluoranthene or the like can be given.

As the compound represented by the formula (4), a simple body or a derivative of a substituted or unsubstituted naphthalene or the like can be given.

As the naphthalene derivative, one represented by the following formula (4A) can be given.

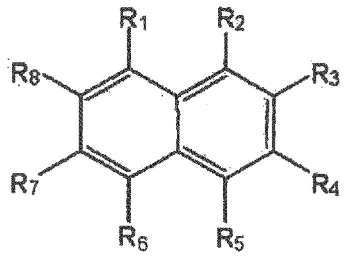

... (4 A)

In the formula (4A), $R_1$ to $R_8$ are independently a hydrogen atom or a substituted or unsubstituted aryl group having 5 to 30 ring carbon atoms, a branched or straight-chain alkyl group having 1 to 30 carbon atoms or a substituted or unsubstituted cycloalkyl group having 3 to 20 carbon atoms, singly or in combination.

As the phenanthrene derivative, one represented by the following formula (5A) can be given, for example.

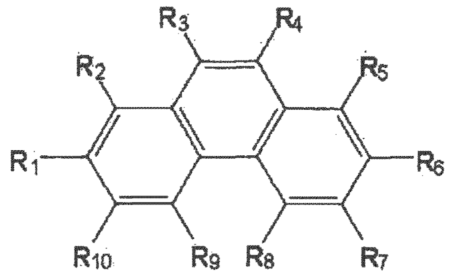

... (5A)

In the formula (5A), $R_1$ to $R_{10}$ are independently a substituent formed of a hydrogen atom or a substituted or unsubstituted aryl group having 5 to 30 ring carbon atoms, a branched or straight-chain alkyl group having 1 to 30 carbon atoms or a substituted or unsubstituted cycloalkyl group having 3 to 20 carbon atoms, singly or in combination.

As the chrysene derivative, one represented by the following formula (6A) can be given.

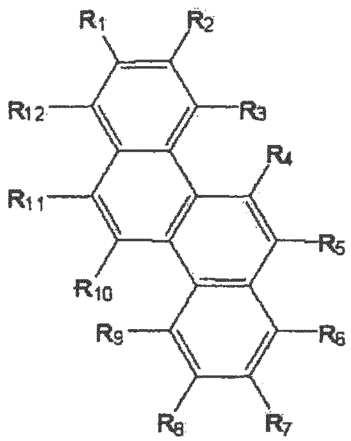

... (6A)

In the formula (6A), $R_1$ to $R_{12}$ are independently a hydrogen atom or a substituted or unsubstituted aryl group having 5 to 30 ring carbon atoms, a branched or straight-chain alkyl group having 1 to 30 carbon atoms, and a substituted or unsubstituted cycloalkyl group having 3 to 20 carbon atoms, singly or in combination.

It is preferred that the above-mentioned polycyclic aromatic skeleton part be a benzo[c]phenanthrene or its derivative. As the benzo[c]phenanthrene derivative, one represented by the following formula (7A) can be given, for example.

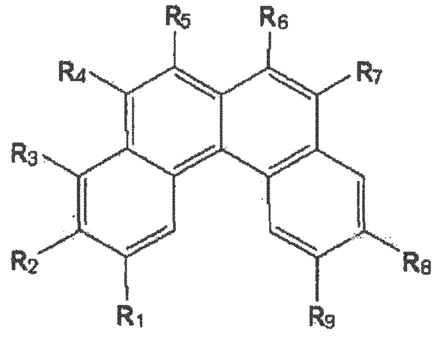

... (7A)

In the formula (7A), $R_1$ to $R_9$ are independently a hydrogen atom or a substituent formed of a substituted or unsubstituted aryl group having 5 to 30 ring carbon atoms, a branched or straight-chain alkyl group having 1 to 30 carbon atoms or a substituted or unsubstituted cycloalkyl group having 3 to 20 carbon atoms, singly or in combination.

It is preferred that the above-mentioned polycyclic aromatic skeleton part be benzo[c]chrysene or its derivatives. As the benzo[c]chrysene derivative, one represented by the following formula (8A) can be given, for example.

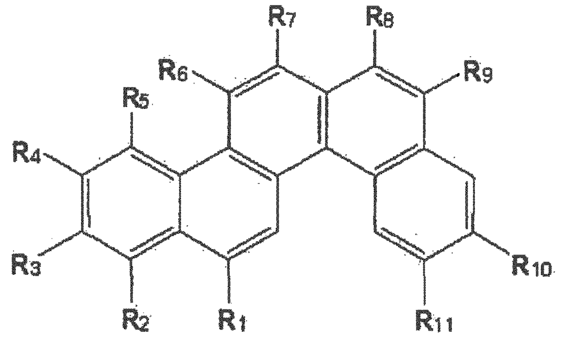

... (8A)

In the formula (8A), $R_1$ to $R_{11}$ are independently a hydrogen atom, or a substituent formed of a substituted or unsubstituted aryl group having 5 to 30 ring carbon atoms, a branched or straight-chain alkyl group having 1 to 30 carbon atoms, and a substituted or unsubstituted cycloalkyl group having 3 to 20 carbon atoms, singly or in combination.

It is preferred that the above- mentioned polycyclic aromatic skeleton part be dibenzo [c, g] phenanthrene represented by the following formula (9) or its derivative.

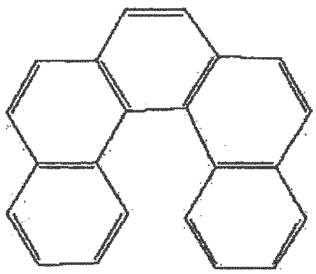

... (9)

It is preferred that the polycyclic aromatic skeleton part be fluoranthene or its derivative. As the fluoranthene derivative, one represented by the following formula (10A) can be given, for example.

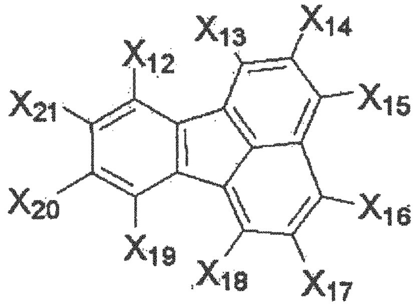

... (10A)

In the formula (10A), $X_{12}$ to $X_{21}$ is a hydrogen atom, a halogen atom, a straight-chain, branched or cyclic alkyl group, a straight-chain, branched or cyclic alkoxy group, a substituted or unsubstituted aryl group or a substituted or unsubstituted heteroaryl group.

It is preferred that the polycyclic aromatic skeleton part be triphenylene or its derivative. As the triphenylene derivative, one represented by the following formula (11A) can be given, for example.

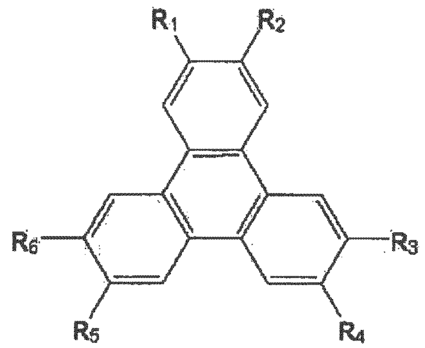

... (11A)

In the formula (11A), $R_1$ to $R_6$ are independently a hydrogen atom or a substituent formed of a substituted or unsubstituted aryl group having 5 to 30 ring carbon atoms, a branched or straight-chain alkyl group having 1 to 30 carbon atoms, a substituted or unsubstituted cycloalkyl group having 3 to 20 carbon atoms, singly or in combination.

The above-mentioned polycyclic aromatic compound may be one represented by the following formula (12).

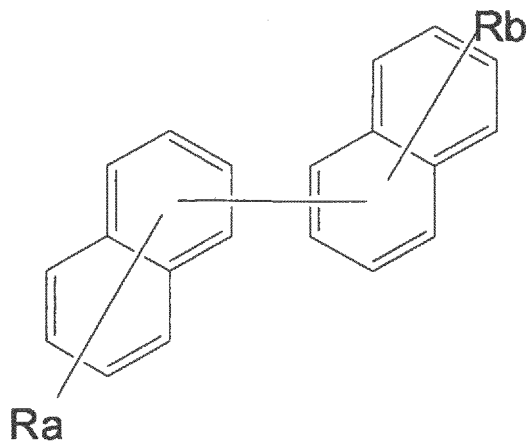

···(12)

In the formula (12), Ra and Rb are as defined in the above formulas (A) to (C). If Ra, Rb and a naphthalene ring each has one or a plurality of substituents, the substituent may be an alkyl group having 1 to 20 carbon atoms, a haloalkyl group having 1 to 20 carbon atoms, a cycloalkyl group having 5 to 18 carbon atoms, a silyl group having 3 to 20 carbon atoms, a cyano group or a halogen atom. The substituent of the naphthalene ring other than Ra and Rb may further be an aryl group having 6 to 22 carbon atoms.

In the formula (12), it is preferred that Ra and Rb be selected from a fluorene ring, a phenanthrene ring, a triphenylene ring, a benzophenanthrene ring, a dibenzophenanthrene ring, a benzotriphenylene ring, a fluoranthene ring, a benzochrysene ring, a benzo[b]fluoranthene ring and a picene ring.

As the material for the blocking layer, a nitrogen-containing heterocyclic derivative represented by the following formula (11) or (21) can be used.

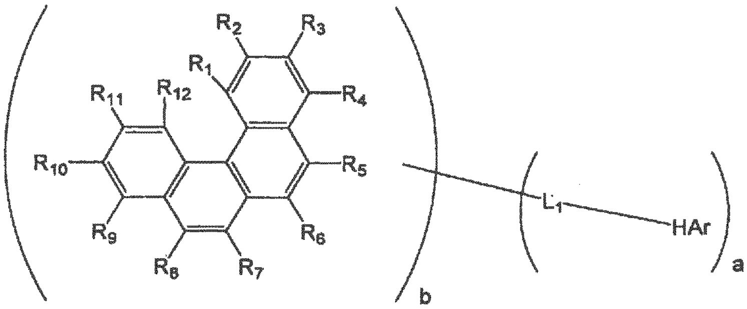

(11)

In the formula, any 12-a of $R_1$ to $R_{12}$ are independently a hydrogen atom, a fluorine atom, a substituted or unsubstituted

aryl group having 6 to 30 ring carbon atoms or a substituted or unsubstituted heterocyclic group having 5 to 30 ring atoms, and any "a" of $R_1$ to $R_{12}$ is a single bond which bonds to $L_1$.
$L_1$ is a single bond, a substituted or unsubstituted b+1 valent hydrocarbon ring group having 6 to 30 ring carbon atoms or a substituted or unsubstituted b+1 valent heterocyclic group having 5 to 30 ring atoms.
HAr is a substituted or unsubstituted nitrogen-containing heterocyclic group.
a and b are independently an integer of 1 to 4, and at least one of a and b is 1.
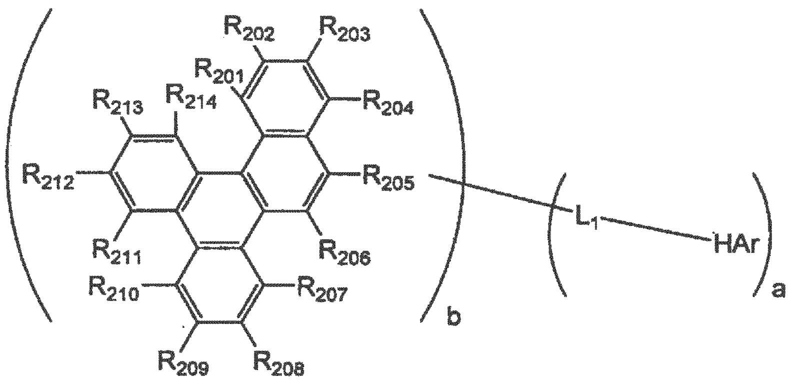

(21)

In the formula, any 14-a of $R_{201}$ to $R_{214}$ are independently a hydrogen atom, a fluorine atom, a substituted or unsubstituted alkyl group having 1 to 10 carbon atoms, a substituted or unsubstituted cycloalkyl group having 3 to 8 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms, provided that any "a" of $R_{201}$ to $R_{214}$ is a single bond which bonds to $L_1$.
$L_1$ is a single bond, a substituted or unsubstituted b+1 valent hydrocarbon ring group having 6 to 30 ring carbon atoms or a substituted or unsubstituted b+1 valent heterocyclic group having 5 to 30 ring atoms.
HAr is a substituted or unsubstituted nitrogen-containing heterocyclic group.
a and b are independently an integer of 1 to 4, and at least one of a and b is 1.
As examples of HAr represented by the above-mentioned formulas (11) and (21), groups represented by the following formulas can be exemplified.

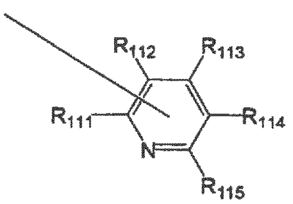
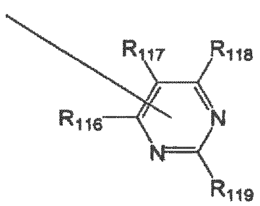
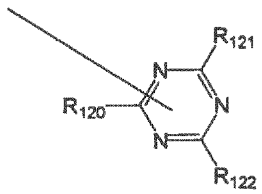

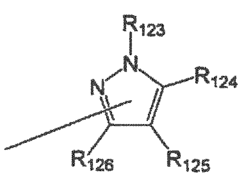
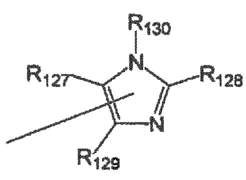

In the formula, $R_{111}$ to $R_{130}$ are independently a hydrogen atom or a substituent, and adjacent substituents of $R_{111}$ to $R_{130}$ may be bonded each other to form a saturated or unsaturated ring.
Any one of $R_{111}$ to $R_{115}$, any one of $R_{116}$ to $R_{119}$, any one of $R_{120}$ to $R_{122}$, any one of $R_{123}$ to $R_{126}$ and any one of $R_{127}$ to $R_{130}$ is a single bond which bonds to $L_1$.
As the material for the blocking layer, a nitrogen-containing heterocyclic derivative represented by the following formula (31) can be used.

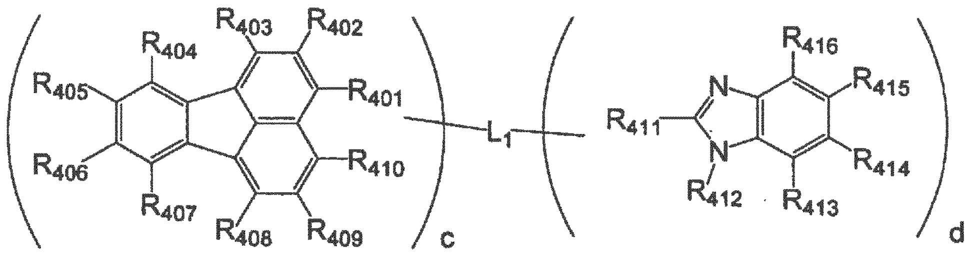

(31)

In the formula, $R_{401}$ to $R_{416}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted alkylamino group, a substituted or unsubstituted arylamino group, a substituted or unsubstituted aryl group having 6 to 30 ring carbon atoms or a substituted or unsubstituted heterocyclic group having 5 to 30 ring atoms. One of $R_{401}$ to $R_{410}$ and one of $R_{411}$ to $R_{416}$ is a single bond, which bonds to $L_1$. Adjacent substituents of $R_{411}$ to $R_{416}$ may form a saturated or unsaturated ring.
$L_1$ is a single bond or a substituted or unsubstituted c+d valent hydrocarbon group having 6 to 30 ring carbon atoms or a substituted or unsubstituted c+d valent heterocyclic group having 5 to 30 ring atoms.
c and d are independently an integer of 1 to 3.
$L_1$ and $R_{401}$ to $R_{416}$ are not an anthracene-containing group.

Further, as the material for the blocking layer, a material having an electron- transporting structure part and a triplet- blocking structure part composed of a fused polycyclic aromatic hydrocarbon compound can be used.

The electron-transporting structure part contains one or more rings selected from the following rings, for example.

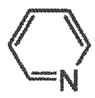 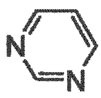 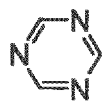 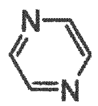 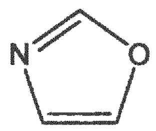 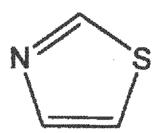 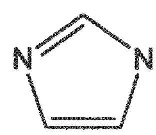

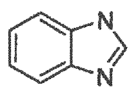 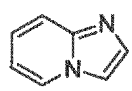 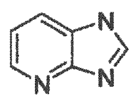 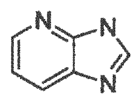

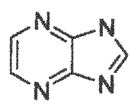 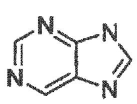 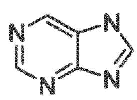

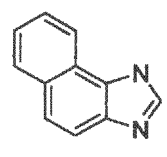 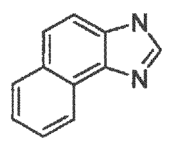

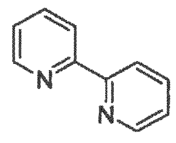 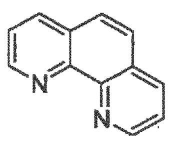

The triplet blocking structure part can be selected from the following rings, for example.

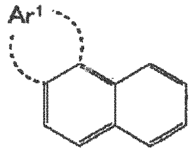

... (1)

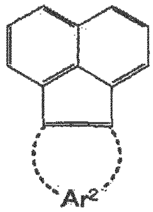

... (2)

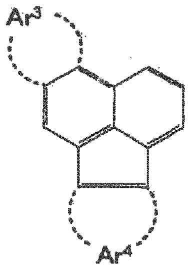

... (3)

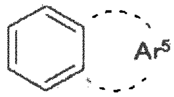

... (4)

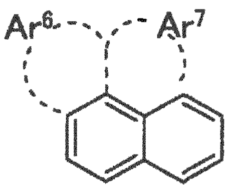

... (5)

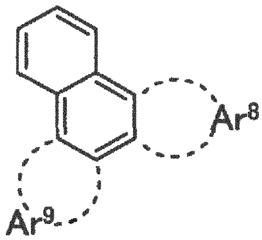

... (6)

In the formulas (1) to (6), $Ar^1$ to $Ar^9$ are a fused ring structure having 4 to 16 ring carbon atoms.

Further, as the material for the blocking layer, phenanthroline derivatives represented by the following formulas (I) and (II) can be used.

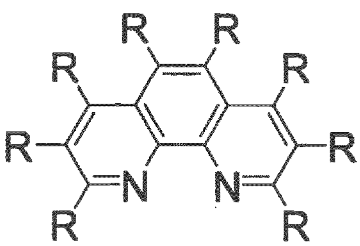

(I)

In the formula, Rs are independently a hydrogen atom, a fluorine atom, a susbstituted or unsubstituted alkyl group, a substituted or unsubstituted cycloalkyl group, a substituted or unsubstituted aryl group, a substituted or unsubstituted heteroaryl group, a substituted or unsubstituted alkoxy group, a substituted or unsubstituted aryloxy group, a substituted or unsubstituted alkylamino group, a substituted or unsubstituted arylamino group, a substituted or unsubstituted alkylsilyl group, a substituted or unsubstituted arylsilyl group, a nitro group, a cyano group or a group obtained by combining 2 to 3 of the above- mentioned aryl groups and heteroaryl groups.

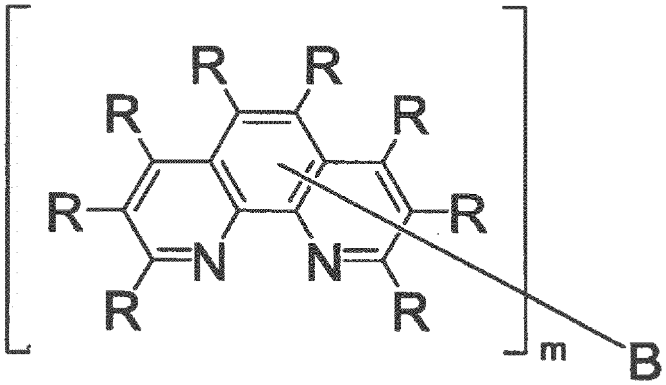

(II)

In the above formula, any one of Rs is bonded to B as a single bond, and the remaining Rs are independently a hydrogen atom, a fluorine atom, a substituted or unsubstituted alkyl group, a substituted or unsubstituted cycloalkyl group, a substituted or unsubstituted aryl group, a substituted or unsubstituted heteroaryl group, a substituted or unsubstituted alkoxy group, a substituted or unsubstituted aryloxy group, a substituted or unsubstituted alkylamino group, a substituted or unsubstituted alkylsilyl group, a substituted or unsubstituted arylsily group, a nitro group, a cyano group or a group obtained by combining two or three of the aryl group and the heteroaryl group. m is an integer of 2 or more. B is a single bond or a bonding group, a substituted or unsubstituted m-valent alkylene group, a substituted or unsubstituted alkenylene group, a substituted or unsubstituted m-valent arylene group, a substituted or unsubstituted m-valent heteroarylene group, a m-valent group obtained by combining 2 to 4 of the aryl groups and the heteroaryl groups or a m-valent group represented by the following formula (b).

$$Ar^{1'}\text{- Y- }Ar^{2'} \qquad \text{(b)}$$

in the formula (b), $Ar^{1'}$ and $Ar^{2'}$ may be the same or different, and $Ar^{1'}$ is a substituted or unsubstituted (j + 1) valent arylene group or heteroarylene group. $Ar^{2'}$ is a substituted or unsubstituted (k + 1) valent arylene group or heteroarylene group. j and k are independently an integer of 1 or more, and j + k = m; and both $Ar^{1'}$ and $Ar^{2'}$ bond to the phenanthroline structure represented by the formula (II) . Y is O, S or $CR'_2$, and $R'_2$s are independently a substituted or unsubstituted alkyl group, a substituted or unsubstituted aryl group or a substituted or unsubstituted heteroaryl group, and $R'_2$s may be bonded to form a saturated or unsaturated ring.

In the above-mentioned phenanthroline derivative, as the aryl group, a phenyl group, a biphenyl group, an o-terphenyl group, an m-terphenyl group, a p-terphenyl group, a naphthyl group, a phenanthryl group, a chrysenyl group, a benzophenanthryl group, a benzochrysenyl group, a benzanthryl group, a triphenyl group, a fluoranthenyl group, a benzofluororanthenyl group, a fluorenyl group or the like can be given. As the heteroaryl group, a pyridyl group, a pyrimidyl group, a pyrazinyl group, a pyridazinyl group, a quinolynyl group, an isoquinolynyl group, a quinoxaliny group, a naphthylidiny group, an imidazopyridyl group, an indolyl group, an indazolyl group, a phenanthrolinyl group, an imidazolyl group, a pyrazolyl group, a pyrrolyl group, a furanyl group, a thiophenyl group, an oxazolyl group, a thiazolyl group, a benzoxazolyl group, a benzothiazolyl group, an oxadiazolyl group, a thiazolyl group, a triazolyl group, a tetrazolyl group, a dibenzofuranyl group, a dibenzothiophenyl group, a carbazolyl group or the like can be given.

As the material for the blocking layer, a nitrogen-containing heterocyclic derivative represented by the following formula can be given.

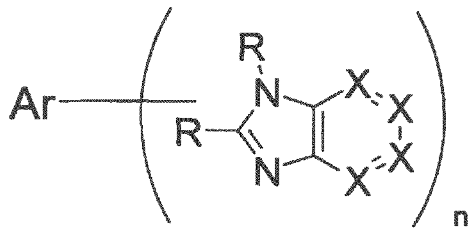

In the formula, Ar is a substituted or unsubstituted arylene group or a substituted or unsubstituted heteroarylene group. Xs are independently CR or N. Any one of Rs bonds to Ar as a single bond, and the remaining Rs are independently a hydrogen atom, a fluorine atom, a substituted or unsubstituted alkyl group, a substituted or unsubstituted cycloalkyl group, a substituted or unsubstituted aryl group, a substituted or unsubstituted heteroaryl group, a substituted or unsubstituted alkoxy group, a substituted or unsubstituted aryloxy group, a substituted or unsubstituted alkylamino group, a substituted or unsubstituted arylamino group, a substituted or unsubstituted alkylsilyl group, a a substituted or unsubstituted arylsilyl group, a nitro group, a cyano group or a group obtained by combining 2 to 3 of the aryl group or the heteroaryl group. n is an integer of 2 or 3.

In the above, as the aryl group, a phenyl group, a biphenyl group, an o-terphenyl group, an m-terphenyl group, a p-terphenyl group, a naphthyl group, a phenanthryl group, a chrysenyl group, a benzophenanthrenyl group, a benzochrysenyl group, a benzoanthryl group, a triphenyl group, a fluoranthenyl group, a benzofluoranthenyl group, a fluorenyl group or the like can be given. As the heteroaryl group, a pyridyl group, a pyrimidinyl group, a pyrazinyl group, a pyridazinyl group, a quinolynyl group, an isoquinolynyl group, a quinoxalinyl group, a naphthyridinyl group, an imidazopyridyl group, an indolyl group, an indazolyl group, a phenanthrolyl group, an imidazolyl group, a pyrazolyl group, a pyrrolyl group, a furanyl group, a thiophenyl group, an oxazolyl group, a thiazolyl group, a benzoxazolyl group, a benzothiazolyl group, an oxathiazolyl group, a thiadiazolyl group, a triazolyl group, a tetrazolyl group, a dibenzofuranyl group, a dibenzothiophenyl group, a carbazolyl group or the like can be given. The arylene group is a divalent or trivalent residue of the above-mentioned aryl group and the heteroarylene group is a divalent or trivalent residue of the above-mentioned heteroaryl group.

As the material for the blocking layer, an oxygen-containing fused ring derivative represented by the following formula can be used.

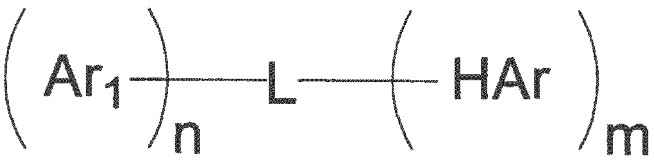

In the formula, $Ar_1$ is a fused ring group which is obtained by fusing of 4 or more rings and has one or more rings selected from a furan ring and a pyran ring.

HAr is any of the nitrogen-containing heterocyclic groups represented by the following formula.

n and m are independently an integer of 1 to 5.

L is a single bond, a substituted or unsubstituted n + m valent aryl group having 6 to 30 ring carbon atoms, a substituted or unsubstituted n + m valent heterocyclic group having 5 to 30 ring atoms, or a n + m valent group obtained by combining though a single bond two or three selected from a substituted or unsubstituted aryl group having 6 to 30 ring carbon atoms and a substituted or unsubstituted heterocyclic group having 5 to 30 ring atoms.

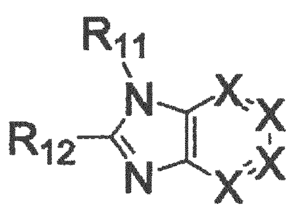

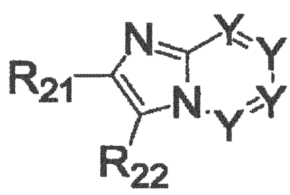

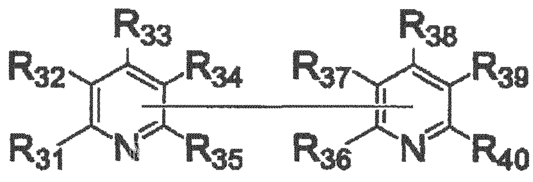

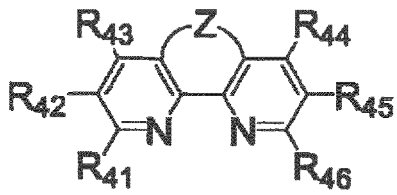

in the formula, $R_{11}$, $R_{12}$, $R_{21}$, $R_{22}$, $R_{31}$ to $P_{40}$ and $R_{41}$ to $R_{46}$ are independently a hydrogen atom, a halogen atom, a substituted or unsubstituted alkyl group having 1 to 10 carbon atoms, a substituted or unsubstituted cycloalkyl group having 3 to 8 ring carbon atoms, a substituted silyl group having 3 to 30 carbon atoms, a cyano group, a substituted or unsubstituted alkoxy group having 1 to 20 carbon atoms, a substituted or unsubstituted aryloxy group having 6 to 20 ring carbon atoms, a substituted or unsubstituted alkylthio group having 1 to 20 carbon atoms, an amino group, a substituted or unsubstituted mono- or dialkylamino group having 1 to 20 carbon atoms, a substituted or unsubstituted aryl group having 6 to 30 ring carbon atoms or a substituted or unsubstituted heterocyclic group having 5 to 30 ring atoms.

Any one of $R_{31}$ to $R_{35}$ and any one of $R_{36}$ to $R_{40}$ is a single bond which bonds two pyridine rings in the formula (4).

X is N or $CR_{13}$, $R_{13}$ is a hydrogen atom, a halogen atom, a substituted or unsubstituted alkyl group having 1 to 10 carbon atoms, a substituted or unsubstituted cycloalkyl group having 3 to 8 ring carbon atoms, a substituted or unsubstituted silyl group having 3 to 30 carbon atoms, a cyano group, a substituted or unsubstituted alkoxy group having 1 to 20 carbon atoms, a substituted or unsubstituted aryloxy group having 6 to 20 ring carbon atoms, a substituted or unsubstituted alkylthio group having 1 to 20 carbon atoms, an amino group, a substituted or unsubstituted mono- or dialkylamino group having 1 to 20 carbon atoms, a substituted or unsubstituted aryl group having 6 to 30 ring carbon atoms or a substituted or unsubstituted heterocyclic group having 5 to 30 ring atoms.

When plural $R_{13}$s are present, the plural $R_{13}$s may be the same or different

Y is N or $CR_{23}$. $R_{23}$ is a hydrogen atom, a halogen atom, a substituted or unsubstituted alkyl group having 1 to 10 carbon atoms, a substituted or unsubstituted cycloalkyl group having 3 to 8 ring carbon atoms, a substituted silyl group having 3 to 30 carbon atoms, a cyano group, a substituted or unsubstituted alkoxy group having 1 to 20 carbon atoms, a substituted or unsubstituted aryloxy group having 6 to 20 ring carbon atoms, a substituted or unsubstituted alkylthio group having 1 to 20 carbon atoms, an amino group, a substituted or unsubstituted mono- or dialkylamino group having 1 to 20 carbon atoms, a substituted or unsubstituted aryl group having 6 to 30 ring carbon atoms or a substituted or unsubstituted heterocyclic group having 5 to 30 ring atoms.

When plural $R_{23}$s are present, the plural $R_{23}$s may be the same or different

Z is a cross-linking group, and is a substituted or unsubstituted alkylene group or a substituted or unsubstituted alkenylene group.

Any one of $R_{11}$ to $R_{13}$, any one of $R_{21}$ to $R_{23}$, any one of $R_{31}$ to $R_{40}$ and any one of $R_{41}$ to $R_{46}$ is a single bond that bonds to L.

As the material for the blocking layer, the following carbazole azine- based compound and the ladder- based compound can be used. (1) Carbazole azine- based compound

(Cz- ) mA

in the formula, Cz is a substituted or unsubstituted carbazolyl group or a substituted or unsubstituted azacarbazolyl group; A is an aryl- substituted nitrogen- containing ring group, a diaryl- substituted nitrogen- containing ring group or a triaryl- substituted nitrogen- containing ring group; and m is an integer of 1 to 3.

Cz- An

in the formula, Cz is a substituted or unsubstituted carbazolyl group or a substituted or unsubstituted azacarbazolyl group; A is an aryl- substituted nitrogen- containing ring group, a diaryl- substituted nitrogen- containing ring group or a triaryl- substituted nitrogen- containing ring group; and n is an integer of 1 to 3.

(2) Ladder-based compound

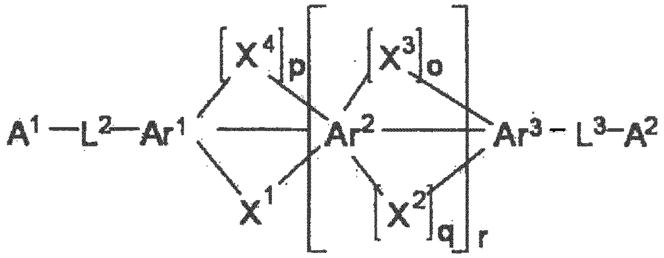 ···(1)

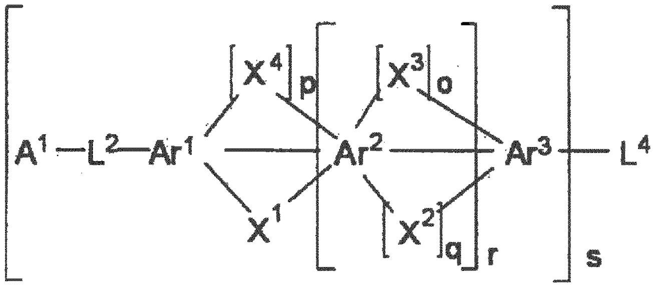 ···(2)

In the formulas (1) and (2), $Ar^1$, $Ar^2$ and $Ar^3$ are independently a substituted or unsubstituted aromatic hydrocarbon group having 6 ring carbon atoms or a substituted or unsubstituted aromatic heterocyclic group having 6 ring atoms. However, $Ar^1$, $Ar^2$ and $Ar^3$ may have one or a plurality of substituent Y, and plural Ys may be the same or different

Y is an alkyl group having 1 to 20 carbon atoms, a substituted or unsubstituted cycloalkyl group having 3 to 20 ring carbon atoms, an alkoxy group having 1 to 20 carbon atoms, an aralkyl group having 7 to 24 carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocyclic group having 3 to 24 ring carbon atoms.

In the formulas (1) and (2), $X^1$, $X^2$, $X^3$ and $X^4$ are independently oxygen (O), sulfur (S), N-$R^1$ or $CR^2R^3$. $R^1$, $R^2$ and $R^3$ are independently an alkyl group having 1 to 20 carbon atoms, a substituted or unsubstituted cycloalkyl group having 3 to 20 ring carbon atoms, an aralkyl group having 7 to 24 carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocyclic group having 3 to 24 ring carbon atoms.

When $X^1$ and $X^2$ are both N-$R^1$ and o and p is 0 and q is 1, or when $X^1$ and $X^3$ are both N-$R^1$ and p and q are 0 and o is 1, at least one of $R^1$s is a substituted or unsubstituted monovalent fused aromatic heterocyclic group having 8 to 24 ring atoms.

In the formulas (1) and (2), o, p and q are independently 0 or 1. s is 1, 2, 3 or 4, which is independently a monomer, a dimer, a trimer or a tetramer, each having $L^4$ as a linking group. r is 1, 2, 3 or 4.

In the formulas (1) and (2), $L^2$ is a single bond, an alkylene group having 1 to 20 carbon atoms, a substituted or unsubstituted cycloalkylene group having 3 to 20 ring carbon atoms, a divalent silyl group or a divalent substituted silyl group having 2 to 20 carbon atoms, a substituted or unsubstituted divalent aromatic hydrocarbon group or fused aromatic hydrocarbon group having 6 to 24 ring carbon atoms or a substituted or unsubstituted divalent aromatic heterocyclic group or fused aromatic heterocyclic group having 3 to 24 ring carbon atoms.

In the formula (1), $L^3$ is a single bond, an alkylene group having 1 to 20 carbon atoms, a substituted or unsubstituted cycloalkylene group having 3 to 20 ring carbon atoms, a divalent silyl group or a divalent substituted silyl group having 2 to 20 carbon atoms, a substituted or unsubstituted aromatic hydrocarbon group or fused aromatic hydrocarbon group having 6 to 24 ring carbon atoms or a substituted or unsubstituted divalent aromatic heterocyclic group or fused aromatic heterocyclic group having 3 to 24 ring carbon atoms.

In the formula (2), $L^4$ is, when s is 2, a single bond, an alkylene group having 1 to 20 carbon atoms, a substituted or unsubstituted cycloalkylene group having 3 to 20 ring carbon atoms, a divalent silyl group or a substituted silyl group having 2 to 20 carbon atoms, a substituted or unsubstituted divalent aromatic hydrocarbon group or fused aromatic hydrocarbon group having 6 to 24 ring carbon atoms or a substituted or unsubstituted divalent aromatic heterocyclic group or fused aromatic heterocyclic group having 3 to 24 ring carbon atoms.

When s is 3, $L^4$ is a saturated hydrocarbon group having 1 to 20 carbon atoms, a substituted or unsubstituted trivalent cyclic saturated hydrocarbon group having 3 to 20 ring carbon atoms, a trivalent silyl group or a trivalent substituted silyl group having 1 to 20 carbon atoms, a substituted or unsubstituted trivalent aromatic hydrocarbon group or fused aromatic

hydrocarbon group having 6 to 24 ring carbon atoms or a substituted or unsubstituted trivalent aromatic heterocyclic group or fused aromatic heterocyclic group having 3 to 24 ring carbon atoms.
When s is 4, $L^4$ is a tetravalent saturated hydrocarbon group having 1 to 20 carbon atoms, a substituted or unsubstituted tetravalent cyclic saturated hydrocarbon group having a 3 to 20 ring carbon atoms, a silicon atom, a substituted or unsubstituted tetravalent aromatic hydrocarbon group or fused aromatic hydrocarbon group having 6 to 24 ring carbon atoms or a substituted or unsubstituted tetravalent aromatic heterocyclic group or fused aromatic heterocyclic group having 3 to 24 ring carbon atoms.

In the formulas (1) and (2), $A^1$ is a hydrogen atom, a substituted or unsubstituted cycloalkyl group having 3 to 20 ring carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocylic group having 3 to 24 ring carbon atoms.

In the formula (1), $A^2$ is a hydrogen atom, a substituted or unsubstituted cycloalkyl group having 3 to 20 ring carbon atoms, a silyl group or a substituted silyl group having 3 to 20 carbon atoms, a substituted or unsubstituted aromatic hydrocarbon group or fused aromatic hydrocarbon group having 6 to 24 ring carbon atoms or a substituted or unsubstituted aromatic heterocyclic group or fused aromatic heterocyclic group having 3 to 24 ring carbon atoms.

A compound represented by the formulas (1) and (2) in which one of $X^1$ and $X^4$ or one of $X^2$ and $X^3$ is an oxygen atom and which has a dibenzofuran structure in its molecule is preferable.
Further, a compound represented by the formulas (1) and (2) in which one of $X^1$ and $X^4$ and one of $X^2$ and $X^3$ are both an oxygen atom and which has a benzofuranodibenzofuran structure in its molecule is preferable.

<Measurement of TTF ratio>

If the triplet energy of the host, that of the dopant and that of the material of the blocking layer satisfy the specific relationship, the ratio of intensity of emission derived from TTF relative to total emission can be 30% or more. As a result, a high efficiency which could not be achieved by a conventionally known fluorescent device can be attained.

The ratio of intensity of emission derived from TTF can be measured by the transitional EL method. The transitional EL method is a technology of measuring the damping behavior (transitional properties) of EL emission after removing DC voltage applied to a device. The EL emission intensity can be divided into emission components from singlet excitons generated by the initial recombination and emission components from singlet excitons generated through a TTF phenomenon. Since the lifetime of singlet excitons is very short, i.e. on the order of nano second, and hence they are immediately damped after removing a DC voltage.

On the other hand, since a TTF phenomenon is emission from singlet excitons generated through triplet excitons having a long life, damping occurs slowly. As mentioned above, since there is a large difference in time period between emission from singlet excitons and emission from triplet excitons, intensity of emission derived from TTF can be determined. Specifically, it can be determined by the following method.

The transitional EL waveform can be measured by the following method (see FIG 3). A pulse voltage waveform output from a voltage pulse generator (PG) is applied to an EL device. The applied voltage waveform is incorporated into an oscilloscope (OSC). If a pulse voltage is applied to an EL device, the EL device generates pulse emission. This emission is incorporated into an oscilloscope (OSC) through a photomultiplier tube (PMT). The voltage waveform and the pulse emission are synchronized, and incorporated into a personal computer (PC).

Further, by analyzing the transitional EL waveform, the ratio of intensity of emission derived from TTF is determined by the following method.

By solving the rate equation of the damping behavior of the triplet excitons, the damping behavior of the emission intensity based on the TTF phenomenon is modeled. The time-dependency of the density nT of triplet excitons in the emitting layer can be expressed by the following rate equation by using a damping rate $\alpha$ due to the life of triplet excitons and a damping rate $\gamma$ by the collision of triplet excitons.

$$\frac{dn_T}{dt} = -\alpha \cdot n_T - \gamma \cdot {n_T}^2$$

If this differential equation is solved approximately, the following equation is obtained. Here, ITTF is the intensity of emission derived from TTF, and A is a constant. In this way, if transitional EL emission is based on TTF, the reciprocal of the root of the intensity is expressed by an approximate straight line. The measured transitional EL waveform data is fitted to the following approximation to obtain constant A. The emission intensity $1/A^2$ at a time (t=0) at which a DC voltage is removed is defined as the rate of emission intensity derived from TTF.

$$\frac{1}{\sqrt{I_{TTF}}} \propto A + \gamma \cdot t$$

A graph on the left shown in FIG 4 is an example of a measurement at which a prescribed DC voltage is applied to an EL device and the voltage is removed. The graph shows a change with time of emission intensity of an EL device. In the graph on the left shown in FIG. 4, a DC voltage is removed at a time of about $3 \times 10^{-8}$ second. The graph is shown with the luminance at which the voltage is removed being 1. After the rapid damping thereafter to about $2 \times 10^{-7}$ second, slow damping components appear. A graph on the right shown in FIG 4 is a graph obtained by taking the time at which the voltage is removed as an original point, and after removing the voltage, the reciprocal of the root of the light intensity to $10^{-5}$ seconds is plotted. It can be understood that the line is approximate to a straight line. When the straight line part is extended to the original point, the value of the intersection A of the vertical axis is 2.41. Then, the rate of intensity of emission derived from TTF obtained from the transitional EL waveform is $1/2.41^2 = 0.17$. Therefore, 17% of the total indensity of emission is derived from TTF.

<Second embodiment>

The device of the invention can have a tandem device configuration having at least two organic layer units including an emitting layer. Between the two emitting layers, an intermediate layer (called also as the intermediate conductor layer, the charge generating layer (CGL)) is present According to the unit, an electron-transporting region can be provided. At least one emitting layer is a fluorescent emitting layer, and a unit including the emitting layer satisfies the above-mentioned requirements. The example of a specific stacking order is shown below. The following emitting layer may be a stacked body of a plurality of emitting layers, or may be one organic layer unit including a charge blocking layer of the third embodiment, described later.

Anode/fluorescent emitting layer/intermediate layer/fluorescent emitting layer/blocking layer/electron injecting layer/cathode

Anode/fluorescent emitting layer/blocking layer/electron injecting layer/intermediate layer/fluorescent emitting layer/cathode

Anode/fluorescent emitting layer/blocking layer/intermediate layer/fluorescent emitting layer/blocking layer/electron injecting layer/cathode

Anode/phosphorescent emitting layer/intermediate layer/fluorescent emitting layer/blocking layer/electron injecting layer/cathode

Anode/fluorescent emitting layer/blocking layer/electron injecting layer/intermediate layer/phosphorescent emitting layer/cathode

FIG. 5 shows one example of an organic EL device according to this embodiment An organic EL device 1 is provided with an anode 10, an emitting layers 22 and 24 and a cathode 40 in this sequence. Between the emitting layers 22 and 24, an intermediate layer 60 is present. In an electron-transporting region 30, an electron injecting layer 34 and a blocking layer 32 are present The blocking layer 32 may be adjacent to the emitting layer 24. The emitting layer 24 may be a fluorescent emitting layer that satisfies the requirements of the invention. The other emitting layer may be a fluorescent emitting layer or a phosphorescent emitting layer. A blocking layer is provided such that it is adjacent to the emitting layer 22, and the emitting layer 24 is a fluorescent emitting layer that satisfies the requirements of the invention.

Between the two emitting layers 22 and 24, an electron-transporting region and/or a hole-transporting region may be present Three or more emitting layers may be present, and two or more intermediate layers may be present When three or more emitting layers are present, an intermediate layer may or may not be present between all emitting layers.

As the intermediate layer, a known material, for example, one disclosed in USP 7,358,661, US Patent Application No. 10/562, 124 or the like can be used.

<Third Embodiment>

A device in this embodiment is provided with an anode, a plurality of emitting layers, an electron transporting region and a cathode in this sequence, and a charge blocking layer is provided between any two of the plurality of emitting layers. The emitting layer which is in contact with the charge blocking layer is a fluorescent emitting layer and satisfies the above requirements.

As the preferred configuration of this embodiment, a configuration as disclosed in Japanese Patent No. 4134280, US Patent No. 2007/0273270A1 and WO2008/023623A1, in which an anode, a first emitting layer, a charge blocking

layer, a second emitting layer and a cathode are stacked in this sequence and an electron-transporting region having a blocking layer which prevents diffusion of triplet excitons between the second emitting layer and the cathode and an electron injecting layer can be given. Here, the charge blocking layer is a layer which serves to adjust carrier injection to the emitting layer and adjust the carrier balance of electrons and holes injected to the emitting layer by providing energy barrier of the HOMO level and the LUMO level between adjacent emitting layers.

The specific examples of such configuration are shown below.

Anode/first emitting layer/charge blocking layer/second emitting layer/electron-transporting region/cathode

Anode/first emitting layer/charge blocking layer/second emitting layer/third emitting layer/electron-transporting region/cathode

Further, between the anode and the first emitting layer, it is desired that a hole-transporting region be provided as in other embodiments.

FIG 6 shows one example of an organic EL device according to this embodiment. The upper part of FIG 6 shows the device configuration and the HOMO level and the LUMO level of each layer. The lower part shows the relationship of energy gap between the third emitting layer and the blocking layer.

This organic EL device is provided with an anode, a first emitting layer, a second emitting layer, a third emitting layer, an electron-transporting region and a cathode in this sequence. Between the first emitting layer and the second emitting layer, a charge blocking layer is present The electron-transporting region is formed of a blocking layer and an electron injecting layer (not shown). The third emitting layer is a fluorescent emitting layer that satisfies the requirements of the invention. The first emitting layer and the second emitting layer may be a fluorescent emitting layer or a phosphorescent emitting layer.

The device of the present embodiment is preferable as the white emitting device, and can emit white color by adjusting the emission colors of the first emitting layer, the second emitting layer and the third emitting layer. Further, it is possible to allow the emitting layer to be only the first emitting layer and the second emitting layer, and to adjust the emission colors of the two emitting layers to be white. At this time, the second emitting layer is a fluorescent emitting layer that satisfies the requirements of the invention.

In particular, by allowing the host of the first emitting layer to be a hole transporting material and adding a fluorescent emitting dopant having a main peak wavelength of 550 nm or more, using the host of the second emitting layer (and the third emitting layer) as an electron transporting material and adding a fluorecent emitting dopant having a main peak wavelength of 550 nm or less, it is possible to realize a white emitting device having a luminous efficiency higher than that of a conventional white emitting device although being fully composed of fluorescent materials.

If reference is made particularly to a hole-transporting layer which is adjacent to the emitting layer, in order to allow the TTF phenomenon of the invention to occur efficiently, when comparison is made between the triplet energy of the hole-transporting material and that of the host, it is preferred that the triplet energy of the hole-transporting material be large.

<Fourth embodiment>

In this embodiment, a blue pixel, a green pixel and a red pixel are provided on the substrate side by side. Of these three color pixels, the blue pixel constitutes the constitution of the first embodiment

FIG. 7 shows one example of the organic EL device according to this embodiment.

In a top-emitting organic EL device 2 shown in this figure, on a common substrate 100, blue pixels B, green pixels G and red pixels R are formed in parallel.

A blue pixel B is provided with an anode 10, a hole-transporting region 50, a blue emitting layer 20B, an electron-transporting region 30 formed of a blocking layer and an electron-injecting layer, a cathode 40 and a protective layer 70 sequentially on the substrate 100.

A green pixel G is provided with an anode 10, a hole-transporting region 50, a green emitting layer 20G an electron-transporting region 30 formed of a blocking layer and an electron-injecting layer, a cathode 40 and a protective layer 70 sequentially on the substrate 100.

A red pixel R is provided with an anode 10, a hole-transporting region 50, a red emitting layer 20R, an electron-transporting region 30 formed of a blocking layer and an electron-injecting layer, a cathode 40 and a protective layer 70 sequentially on the substrate 100.

Between the anodes of adjacent pixels, an insulating film 200 is formed, whereby insulation between the pixels is retained.

In the organic EL device 2, a blocking layer is commonly provided in the blue pixel B, the red pixel R and the green pixel G

The effects of the blocking layer are significant as compared with the luminous efficiency which was obtained in the conventional blue fluorescent emitting device. In a green fluorescence device and a red fluorescence device, it is possible to obtain the same effects of confining the triplet energy in the emitting layer, and improvement in luminous efficiency can be expected.

On the other hand, in the phosphorescent emitting layer, it is possible to obtain effects of confining triplet excitons in the

emitting layer. As a result, diffusion of triplet energy is prevented, thereby contributing to improvement in luminous efficiency of a phosphorescent emitting dopant.

The hole-transporting region is formed of a hole-transporting layer, a hole-transporting layer, a hole-injecting layer or the like. The hole-transporting region may be common or different. Normally, the hole-transporting region has a configuration which is suited to the emission color.

An organic layer formed of the emitting layer 20B, G, R and the blocking layer is not limited to the configuration shown in the figure and can be changed appropriately.

EXAMPLES

The materials and physical properties used in Examples and Comparative Examples are as follows.

[Hole injecting material]

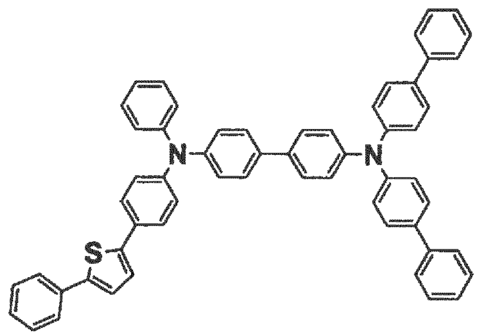

HI1

[Hole transporting material]

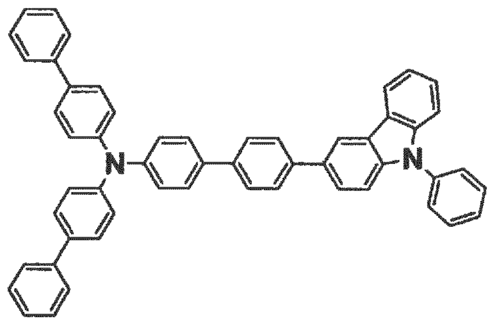

HT2

$E^T$=2. 6eV

[Host material]

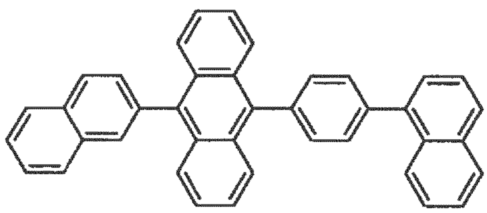

BH

$E^T$=1. 83eV

Affinity =3eV

[Dopant material]

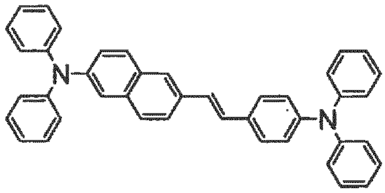

BD-1

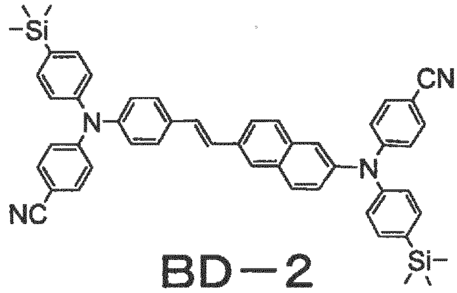

BD-2

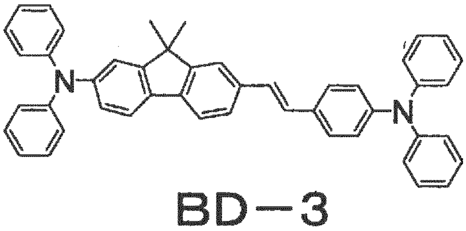

BD-3

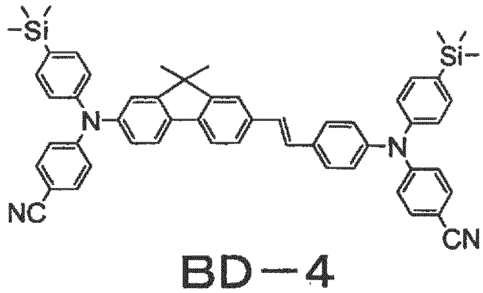

BD-4

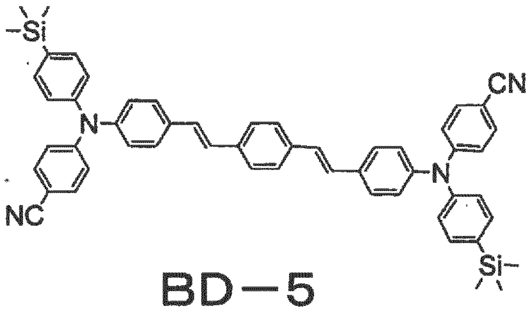

BD-5

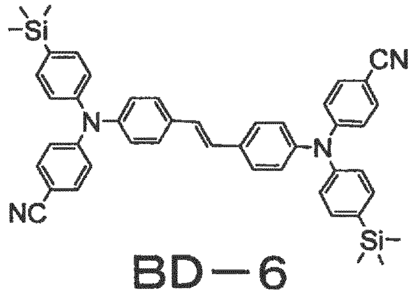

BD-6

[Material for blocking layer]

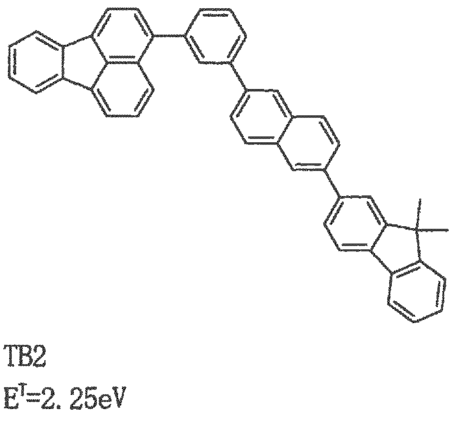

TB2

$E^T$=2. 25eV

Affinity =2. 9eV

[Electron injecting material]

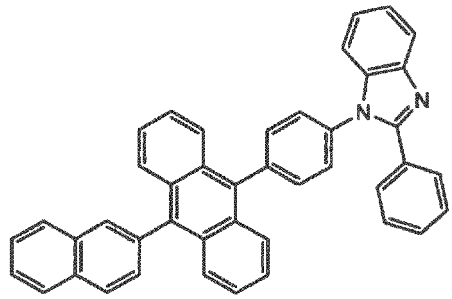

ET

$E^T$=1.82eV

Affinity =3eV

The method for measuring the above-mentioned physical value is as follows.

(1) Triplet energy ($E^T$)

The triplet energy was measured by a commercially available device (F-4500, manufactured by Hitachi Ltd.). The conversion formula of $E^T$ is as follows.

$$\text{Conversion formula ET (eV)} = 1239.85/\lambda_{ph}$$

The "$\lambda_{ph}$" (unit nm) means, when the phosphorescent intensity and the wavelength are taken at the vertical axis and the horizontal axis respectively to express a phosphorescent spectrum and a tangential line is drawn against the rise on the shorter wavelength side of the phosphorescent spectrum, a wavelength value of the intersection of the tangential line and the horizontal axis (unit nm).
Each compound is dissolved in a solvent (sample 10 μmol/l, EPA (diethylether:isopentane:ethanol: 5:5:5 (volume ratio)). Each solvent is spectrally graded to obtain a sample for measuring phosphorescent emission. The sample for measuring phosphorescent emission put in a quarts cell was cooled to 77K, and then irradiated with excited light. The phosphorescent intensity was measured while changing the wavelength. In the phosphorescent spectrum, the vertical axis was the phosphorescent intensity and the horizontal axis was the wavelength.
A tangent line was drawn against the rise of the short-wavelength side of this phosphorescent spectrum, and a wavelength value $\lambda_{ph}$ (nm) of the intersection of the tangent line and the horizontal axis was obtained.
The tangent line against the rise on the short-wavelength side of the phosphorescent spectrum is drawn as follows. When moving on the spectrum curve from the short wavelength side of the phosphorescent spectrum to the maximum value of the shortest wavelength side, a tangent line at each point on the curve towards the long-wavelength side is taken into consideration. The slope of this tangent line increases with a rise in the curve (i.e. as the vertical axis is increased). This tangent line drawn at a point where this value of slope becomes maximum is taken as the tangent line relative to the rise on the short wavelength side of the phosphorescent spectrum.
The maximum point having a peak intensity which is 10% or less of the maximum peak intensity of the spectrum is not included in the maximum value on the shortest wavelength side, and a tangent line which is taken at a point which is closest to the maximum value on the shortest wavelength side and where the value of the slope becomes the maximum is taken as a tangent line taken against the edge on the shorter wavelength side of the phosphorescent spectrum.

(2) Affinity (Af)

Affinity was calculated from the measured value of the ionization potential Ip and the energy gap Eg. The calculation was conducted as follows.

$$Af = Ip - Eg$$

The energy gap Eg was measured from the absorption edge of the absorption spectrum of the toluene solution. Specifically, an absorption spectrum was measured by means of a commercially available UV-visible spectrophotometer and the energy gap was calculated from the wavelength of the rise on the long-wavelength side of the spectrum.
The conversion formula is as follows:

$$Eg\ (eV) = 1239.85/\lambda_{ab}$$

One obtained by taking the absorption on the vertical axis and the wavelength on the horizontal axis is taken as the absorption spectrum. In the above-mentioned conversion formula regarding the energy gap Eg "$\lambda_{ab}$" (unit nm) means the value of a wavelength at the intersection of the tangent line and the horizontal line.
Each compound was dissolved in a toluene solvent (sample $2 \times 10^{-5}$ mol/l) and a sample was prepared such that the optical path became 1 cm. The absorption was measured by changing the wavelength.
The tangent line against the rise on the long-wavelength side of the absorption spectrum is drawn as follows.
Of the maximum values of the absorption spectrum, when moving on the spectrum curve from the maximum value on the longest wavelength side to the long wavelength direction, a tangent line at each point on the curve is taken into consideration. As the curve rises down (i.e. as the vertical axis is decreased), the slope of this tangent line is decreased and then increased. This increase and decrease are repeated. A tangent line drawn at a point where the value of the slope become the minimum in the longest wavelength side (however, a case when the absorption becomes 0.1 or less is excluded) is taken as a tangent line against the rise on the longest wavelength side of the absorption spectrum.
The maximum point at which the value of absorption is 0.2 or less is not included in the maximum value of the maximum value on the longest wavelength side.

(3) Ionization potential (Ip)

An ionization potential was measured by a method in which a single layer of each layer was formed on an ITO glass substrate separately by vacuum deposition, and measured by means of a photoelectron spectrometer (AC-3, manufactured by RIKEN Co., Ltd.) in the atmosphere by means of a thin film on the ITO glass substrate. Specifically, the material is irradiated with light, and the amount of electrons generated by charge separation is measured.
The one-half of the amount of photoelectrons emitted are plotted relative to the energy, and the threshold value of the photoelectron emission energy is taken as the ionization potential (Ip).

Example 1

On an ITO substrate on which ITO was formed in 130 nm, HI1, HT2, BH, BD-1, TB2 and ET were sequentially deposited, whereby a device having the following configuration was obtained. A value in the parenthesis shows a film thickness (unit nm).

ITO (130)/HI1(50)/HT2(45)/BH:BD-1 (25:5 wt%)/TB2(5)/ET(20)/LiF(1)/Al(80)

Examples 2 to 6

Devices were obtained in the same manner as in Example 1, except that the dopant shown in Table 1 was used instead of BD-1.

Comparative Examples 1 to 6

Devices were fabricated in the same manner as in Example 1, except that dopants shown in Table 1 were used instead of BD-1, the blocking layer was not formed and the film thickness of ET was changed to 25 nm.

Evaluation Example 1

For the devices obtained in Examples 1 to 6 and Comparative Examples 1 to 6, the following evaluation was conducted. The results are shown in Table 1.
A voltage was applied to the device such that the current value became 1 mA/cm$^2$, and the voltage value at this time was measured. The EL emission spectrum at this time was measured by means of a spectroradiometer (CS-1000,

manufactured by Konica Minolta Japan). From the resulting spectrum of a spectroradiometer, a current efficiency UJ (cd/A), an external quantum efficiency EQE (%) and a main peak wavelength $\lambda_p$ (nm) were calculated.

Table 1

| | BD | TB | λp (nm) | L/J (cd/A) | EQE (%) |
|---|---|---|---|---|---|
| Ex. 1 | BD-1 | TB2 | 456 | 9.5 | 8.3 |
| Com. Ex. 1 | BD-1 | BD-1 | 456 | 8.1 | 7.1 |
| Ex. 2 | BD-2 | TB2 | 448 | 5.9 | 7.0 |
| Com. Ex. 2 | BD-2 | - | 448 | 5.5 | 6.6 |
| Ex. 3 | BD-3 | TB2 | 452 | 10.6 | 9.3 |
| Com. Ex. 3 | BD-3 | - | 452 | 9.1 | 8.0 |
| Ex. 4 | BD-4 | TB2 | 447 | 7.9 | 8.8 |
| Com. Ex. 4 | BD-4 | - | 446 | 6.5 | 7.3 |
| Ex. 5 | BD-5 | TB2 | 460 | 12.0 | 8.2 |
| Com. Ex. 5 | BD-5 | - | 460 | 10.9 | 7.4 |
| Ex. 6 | BD-6 | TB2 | 441 | 4.4 | 6.4 |
| Com. Ex. 6 | BD-6 | - | 441 | 3.9 | 5.8 |

In Comparative Examples 1 to 6, since no blocking layer was formed, triplet excitons were not confined, and as a result, lowering in efficiency was observed as compared with in Examples 1 to 6. That is, in Examples 1 to 6, the effects of the blocking layer in the invention were exhibited.

Evaluation Example 2

For the devices obtained in Example 3 and Comparative Example 3, the TTF ratio was measured by the following method. As a result, a TTF ratio of 25% was observed in the device of Example 3 and a TTF ratio of 12% was observed in the device of Comparative Example 3.
A voltage (corresponding to pulse width: 500 $\mu$ second, frequency: 20 Hz, Voltage: 0.1 to 100 $mA/cm^2$) was applied which was output from a pulse generator (Agilent Technologies, 8114A), and the EL emission was input to a photoelectron multiplier (R928, Hamamatsu Photonics, K.K.). The pulse voltage waveform and EL emission were synchronized and incorporated into an oscilloscope (2440, Tektronix Inc.), whereby a transitional EL waveform was obtained. An emission ratio (TTF ratio) derived from TTF was determined by analyzing the transitional EL waveform.

INDUSTRIALAPPLICABILITY

The organic EL device according to the present invention can be used for a display panel for a large-sized TV, an illumination panel or the like, for which low power consumption is required.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.
The documents described in the specification are incorporated herein by reference in its entirety.

**Claims**

1. An organic electroluminescence device comprising an anode, an emitting layer, a blocking layer, an electron-injecting layer and a cathode in this sequence,
the emitting layer comprises a host and a styrylamine derivative represented by the following formula (1) or (2); and the triplet energy of the blocking layer is larger than the triplet energy of the host

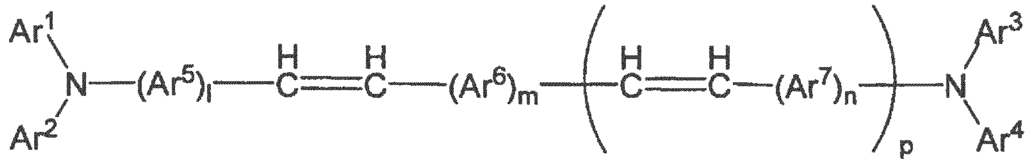

(1)

in the formula (1), $Ar^1$ to $Ar^4$ are independently a substituted or unsubstituted aryl group or a substituted or unsubstituted heteroaryl group;
$Ar^5$ to $Ar^7$ are independently a substituted or unsubstituted arylene group or a substituted or unsubstituted heteroarylene group;
l, m and n are independently an integer of 1 to 3 and p is an integer of 0 to 2;
when l is 2 or more, $Ar^5$s may be the same or different;
when m is 2 or more, $Ar^6$s may be the same or different;
when p is 1 or more and n is 2 or more, $Ar^7$s may be the same or different;
when p is 2 or more and n is 1, $Ar^7$s may be the same or different;
the substituents of $Ar^1$ to $Ar^7$ are a halogen atom, an alkyl group, an aryl group, a heteroaryl group, an alkoxy group, a substituted or unsubstituted silyl group or a cyano group;
provided that when p is 0 and $(Ar^5)_l$ is a biphenylene group, $(Ar^6)_m$ is an arylene group having 7 or more carbon atoms, and when p is 0 and $(Ar^6)_m$ is a biphenylene group, $(Ar^5)_l$ is an arylene group having 7 or more carbon atoms;

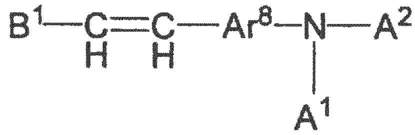

(2)

in the formula (2), $Ar^8$ is a substituted or unsubstituted arylene group or a substituted or unsubstituted heteroarylene group;
$A^1$ and $A^2$ are independently an alkyl group, a substituted or unsubstituted aryl group, a substituted or unsubstituted heteroaryl group or a group represented by the following formula (3):

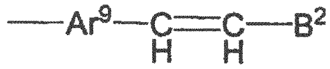

(3)

in the formula (3), $Ar^9$ is a substituted or unsubstituted arylene group or a substituted or unsubstituted heteroarylene group, $B^2$ is a substituted or unsubstituted aryl group or a substituted or unsubstituted heteroaryl group; when $A^1$ and $A^2$ are both groups represented by the formula (3), $Ar^9$ and $B^2$ may be the same or different;
$B^1$ is a substituted or unsubstituted aryl group or a substituted or unsubstituted heteroaryl group;
the substituents of $Ar^8$ to $Ar^9$, $A^1$, $A^2$, $B^1$ and $B^2$ are a halogen atom, an alkyl group, an aryl group, a heteroaryl group, an alkoxy group or a substituted or unsubstituted silyl group or a cyano group.

**2.** The organic electroluminescence device according to claim 1, wherein $Ar^1$ to $Ar^4$, $A^1$, $A^2$, $B^1$ and $B^2$ each have at least one or more substituents selected from a cyano group, a fluorine atom and a substituted or unsubstituted silyl group.

**3.** The organic electroluminescence device according to claim 1 or 2, wherein, in the formula (1), p is 0, l is 1 and m is 1.

**4.** The organic electroluminescence device according to claim 1 or 2, wherein, in the formula (1), p is 1, l is 1, m is 1 and n is 1.

**5.** The organic electroluminescence device according to claim 1 or 2, wherein, in the formula (1), p is 0, l is 1 and m is 2.

**6.** The organic electroluminescence device according to claim 1 or 2, wherein, in the formula (1), p is 0, l is 2 and m is 2.

**7.** The organic electroluminescence device according to claim 1 or 2, wherein, in the formula (1), p is 1, l is 2, m is 2 and n is 2.

**8.** The organic electroluminescence device according to claim 1, wherein, in the formula (1), at least one of $Ar^5$ to $Ar^7$ is a substituted or unsubstituted fluorenyl group, a substituted or unsubstituted naphthyl group or a substituted or unsubstituted phenyl group.

**9.** The organic electroluminescence device according to claim 1, wherein, in the formula (2), at least one of $Ar^8$ and $Ar^9$ is a substituted or unsubstituted fluorenyl group, a substituted or unsubstituted naphthyl group or a substituted or unsubstituted phenyl group.

**10.** The organic electroluminescence device according to any of claims 1 to 8, wherein, in the formula (1), a structure between two nitrogens is represented by any of the following formulas:

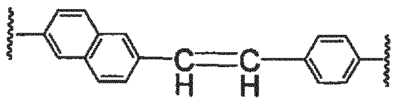
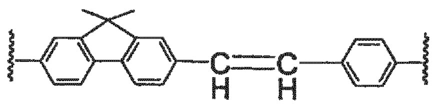
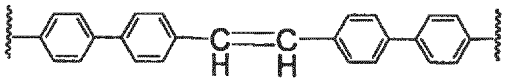
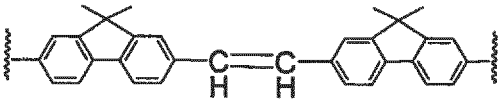
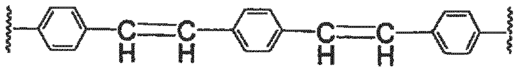
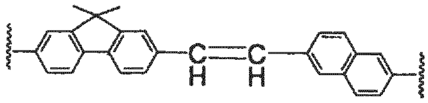
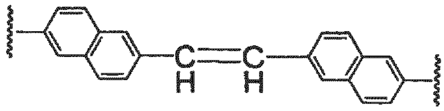
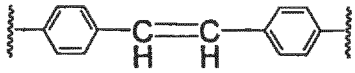
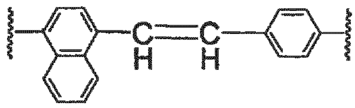
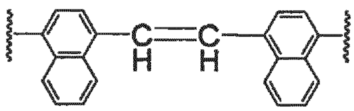
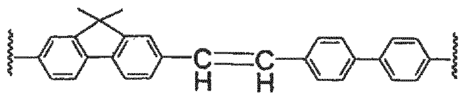
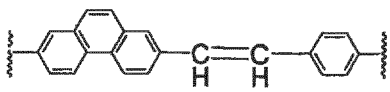
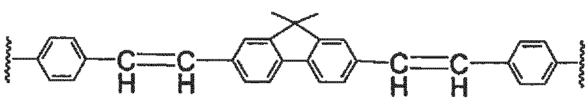
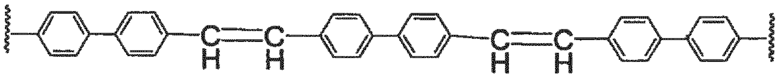

wherein in the formulas, the wavy line at the both ends continue to a nitrogen atom.

FIG.1

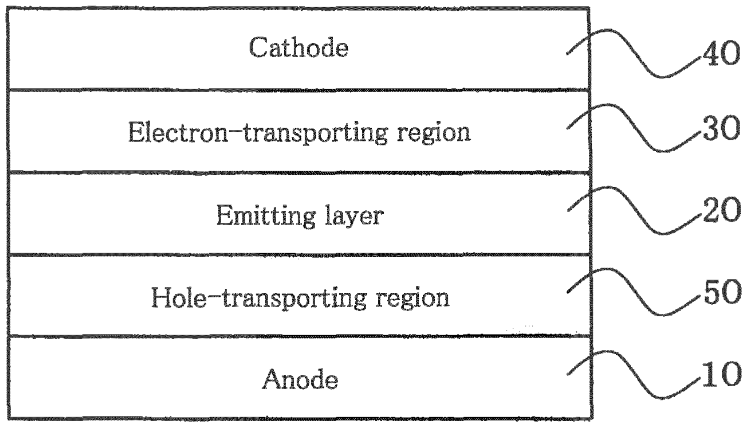


FIG.2A

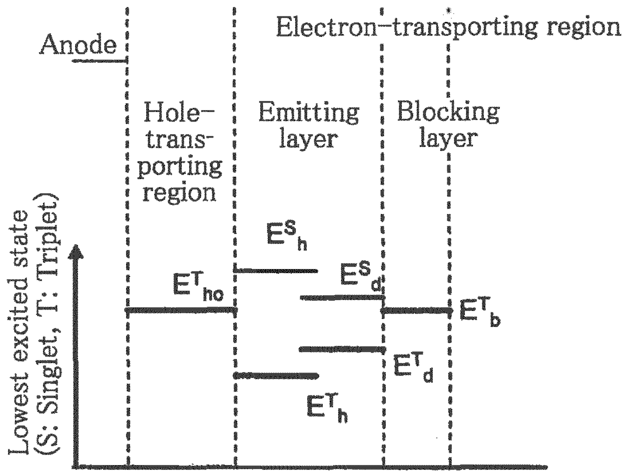


FIG.2B

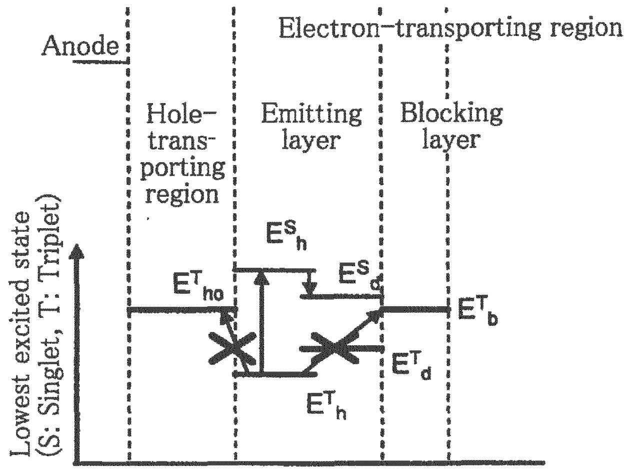

FIG.3

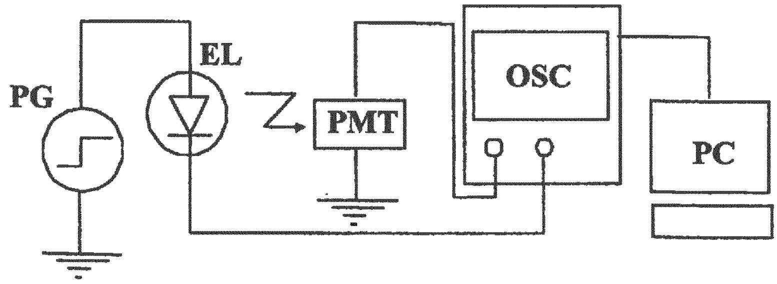


FIG.4

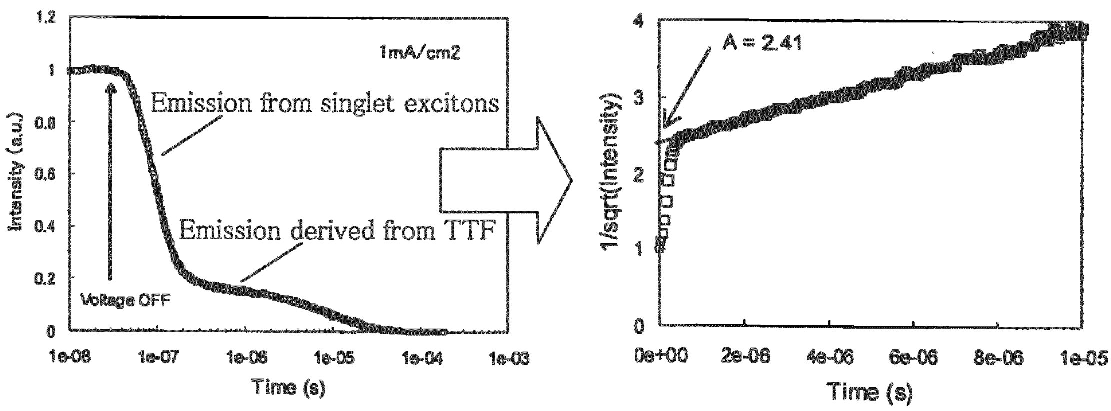


FIG.5

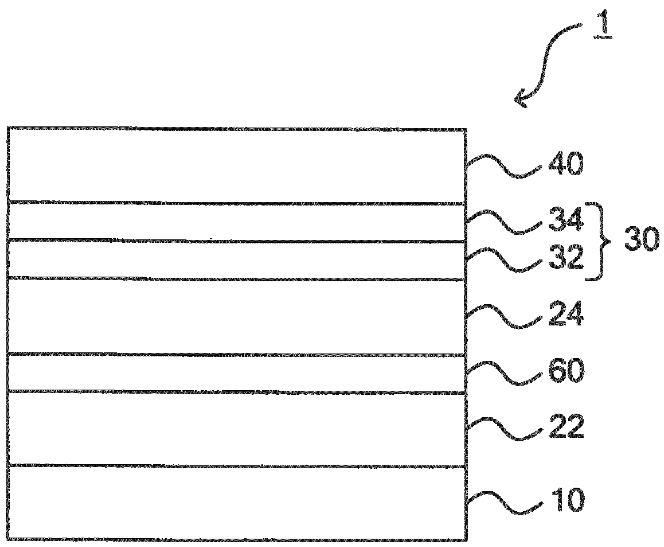

FIG. 6

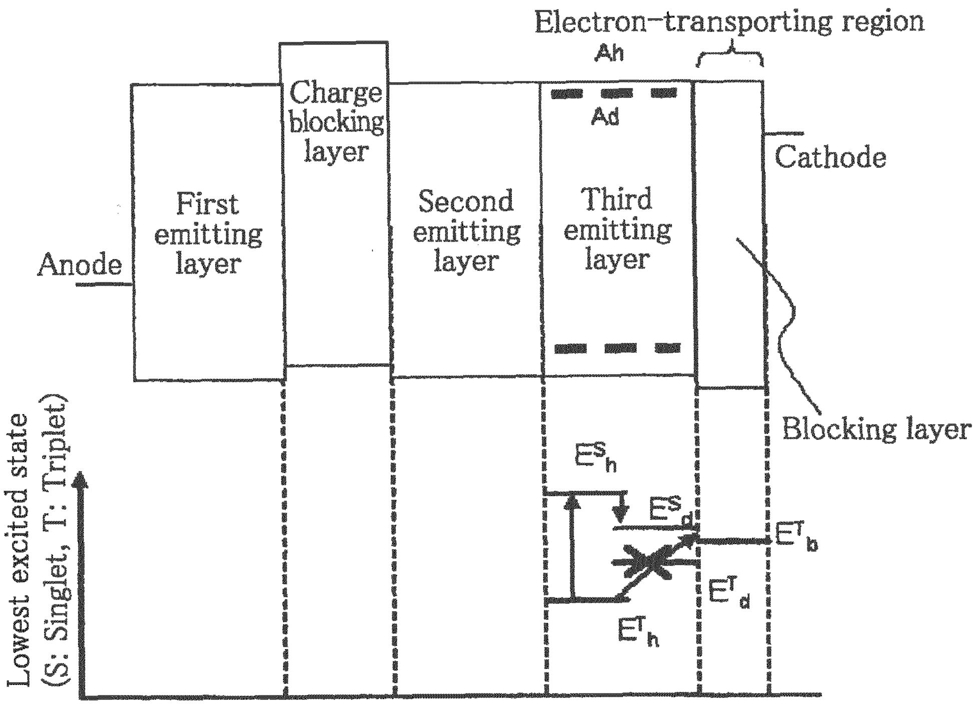
Electron-transporting region
Ah
Ad
Charge blocking layer
Cathode
First emitting layer
Second emitting layer
Third emitting layer
Anode
Blocking layer
Lowest excited state (S: Singlet, T: Triplet)
$E^S_h$
$E^S_d$
$E^T_b$
$E^T_d$
$E^T_h$

FIG. 7

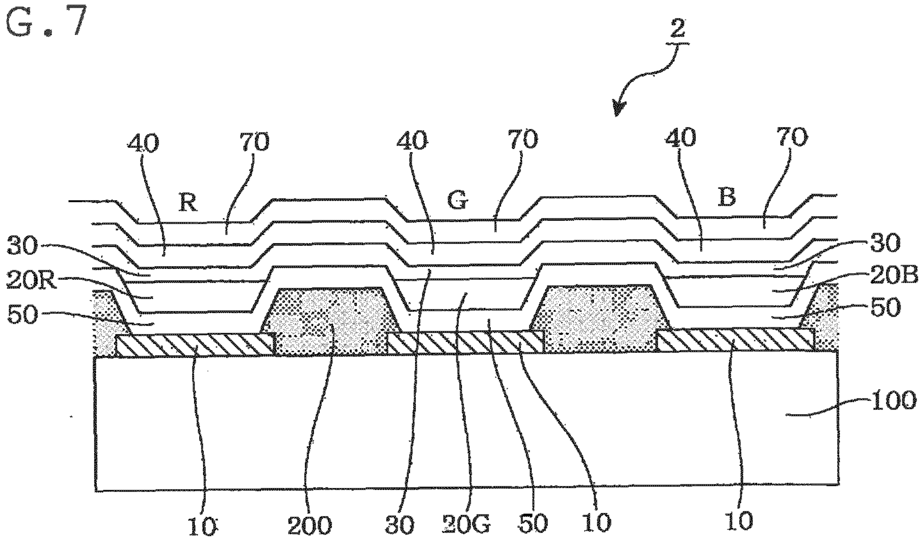
2
40
70
R
G
B
30
20R
50
20B
100
10
200
20G

**INTERNATIONAL SEARCH REPORT**

International application No.
PCT/JP2011/006489

A. CLASSIFICATION OF SUBJECT MATTER
*H01L51/50*(2006.01)i, *C07C211/57*(2006.01)i, *C07C211/58*(2006.01)i, *C07F7/10* (2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C07C211/57, C07C211/58, C07F7/10, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2002-525808 A (The Trustees of Princeton University),<br>13 August 2002 (13.08.2002),<br>claims; paragraphs [0026], [0028]; examples<br>& US 6097147 A1 & WO 2000/016593 A1<br>& KR 10-0698964 B1 | 1,3-5,8,10<br>2,6,7,9 |
| Y<br>A | WO 2010/058995 A1 (GRACEL DISPLAY INC.),<br>27 May 2010 (27.05.2010),<br>claims; examples<br>& EP 2189508 A2 | 1,3-5,8,10<br>2,6,7,9 |
| P,A | JP 2011-176267 A (Fujifilm Corp.),<br>08 September 2011 (08.09.2011),<br>claims; examples<br>(Family: none) | 1-10 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 February, 2012 (01.02.12) | 14 February, 2012 (14.02.12) |
| Name and mailing address of the ISA/<br>Japanese Patent Office<br><br>Facsimile No. | Authorized officer<br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004214180 A
- JP H1079297 A
- JP 2002100478 A
- JP 2003338377 A
- WO 2008062773 A
- WO 2007100010 A
- JP 2002525808 T
- US P7018723 B
- JP 2005072012 A
- JP H11345687 A
- JP 2009090379 A
- US P7358661 B
- US 10562124 A
- JP 4134280 B
- US 20070273270 A1
- WO 2008023623 A1


### Non-patent literature cited in the description


- *Journal of Applied Physics,* 2007, vol. 102, 114504
- *SID 2008 DIGEST,* 2008, vol. 709